# EUROPEAN PATENT APPLICATION

(11) **EP 4 626 151 A1**
(43) Date of publication of application: **01.10.2025**
(21) Application number: 24165988.7
(22) Date of filing: 25.03.2024
(51) Int. Cl.: H05K 1/18, H05K 3/46, H01L 23/538

(54) **COMPONENT CARRIER, METHOD FOR MANUFACTURING THEREOF AND PACKAGE COMPRISING A COMPONENT CARRIER**

(71) Applicant: AT & S Austria Technologie & Systemtechnik Aktiengesellschaft, 8700 Leoben-Hinterberg (AT)
(72) Inventor: LIST, Lukas, 8700 Leoben (AT); KASTELIC, Markus, 8740 Zeltweg (AT); SCHRITTWIESER, Wolfgang, 8605 Kapfenberg (AT)
(74) Representative: Donatello, Daniele

(57) **Abstract**

The present invention relates to a component carrier (100), a method for manufacturing thereof and to a package comprising such a component carrier (100), wherein the component carrier (100) comprises a stack (10, 20) having a stacking direction (Z) and comprises at least one electrically insulating layer structure and at least one electrically conductive layer structure, and further comprising at least a first component (11) and a second component (12) embedded in said stack (10, 20) one above the other in said stacking direction (Z) with a cavity (13) in between, wherein the first component (11) and the second component (12) each comprise a component main surface (14, 16; 24, 26) facing towards said cavity (13) and delimiting said cavity (13) in stacking direction (Z) partially, and wherein said cavity (13) is filled with an electrically conductive paste.

## Description

### FIELD OF THE INVENTION

The present invention generally relates to a component carrier comprising a stack having a stacking direction and comprising a plurality of layer structures, in particular at least one electrically insulating layer structure and at least one electrically conductive layer structure, and further comprising at least a first component and a second component embedded in said stack one above the other in said stacking direction with a cavity in between. Further, the present invention relates to a method for manufacturing a component carrier. Additionally, the present invention relates to a package comprising at least one component carrier.

### TECHNICAL BACKGROUND

Component carriers comprising a stack having a stacking direction and a plurality of layer structures are in general well-known from prior art. It is also known to embed one or more components into the component carrier.

US 2019/0164892 A1, for example, describes a module that has a lower component of a module having a material in which at least one first structural element is embedded, and an upper component of a module having a material in which at least a second component is embedded. The upper component of the module and the lower component of the module are stacked, with the lower and the upper component of the module being electrically connected and mechanically linked to each other.

In US 2019/0109084 A1 a method is disclosed for interconnecting two components. The first component includes a first substrate and a set of structured metal pads arranged on a main surface. Each of the pads includes one or more channels, extending in-plane with an average plane of the pad, so as to form at least two raised structures. The second interconnect component includes a second substrate and a set of metal pillars arranged on a main surface. The structured metal pads are bonded to a respective, opposite one of the metal pillars, using metal paste. The paste is sintered to form porous metal joints at the level of the channels. Metal interconnects are obtained between the substrates. During the bonding, the metal paste is sintered by exposing the structured metal pads and metal pillars to a reducing agent. The channels and raised structures improve the penetration of the reducing agent.

KR 20220018842 A discloses a forming method of Cu-to-Cu flip chip interconnection and Cu-to-Cu flip chip interconnection formed thereby, wherein the method comprises the following steps of: (a) electroplating an under bump metallurgy (UBM) and a pad of a first bonded material with copper to form a copper pillar; (b) forming a copper nanoparticle aggregate layer physically joined to a surface of an upper part of the copper pillar through wet deposition; and (c) locating and aligning the copper nanoparticle aggregate layer formed on the first bonded material on a pad of a second bonded material and heating and sintering at least one of the first bonded material and the second bonded material at a temperature of 250 to 350°C while pressurizing the same under an atmosphere to sinter a contact point portion between the first bonded material and the second bonded material into a solid and make them bonded to each other, thereby forming a Cu-to-Cu flip chip interconnection portion, wherein the copper nanoparticle aggregate layer is one or more selected from a group consisting of i) a copper particle aggregate layer having a copper nano nodule, ii) a copper fractal aggregate layer having a copper nano nodule, and iii) a copper coral aggregate layer having a copper nano nodule. Accordingly, fast sintering bonding can be achieved.

From US 7849591 B2 a configuration is known which includes at least one wired base material configured with an insulating base material having an adhesion property, and an electric conductive layer formed on one side of the insulating base material, a plugging electrode made of an electric conductive paste, connected to the electric conductive layer, and penetrating the insulating base material, and an IC chip having a re-wiring portion, the IC chip being buried in an interlayer binding material, with the re-wiring portion connected to the plugging electrode, having a supporting board disposed on an opposite side to the re-wiring portion of the IC chip, with an adhesion layer in between, and having a re-wiring layer configured with the wired base material and the re-wiring portion. According to the invention, therefore, it is allowed to provide a multi-layer printed wing board with highly defined components implemented, allowing for a fabrication by facile processes, without causing, among others, increased costs or decreased yields.

US 9560770 B2 discloses a component built-in board of multi-layer structure that has a plurality of unit boards stacked therein and is configured having a plurality of electronic components built in thereto in a stacking direction, wherein the plurality of unit boards include: a double-sided board that includes a first insulating layer, a first wiring layer formed on both surfaces of the first insulating layer, and a first interlayer conductive layer that penetrates the first insulating layer and is connected to the first wiring layer, and that comprises an opening in which the electronic component is housed; and an intermediate board that includes a second insulating layer, a first adhesive layer provided on both surfaces of the second insulating layer, and a second interlayer conductive layer that penetrates the second insulating layer along with the first adhesive layer, and the double-sided board is disposed above and below the intermediate board.

US 2014/247570 A1 suggests a circuit board structure having electronic components embedded therein and a method of fabricating the same. The described circuit board structure includes a substrate having a first circuit layer formed on at least one surface thereof, electronic components electrically connected to the first circuit through a metallic connector, a first dielectric layer formed on the first circuit layer of the substrate and having a plurality of dielectric layer cavities for the first circuit layer to be exposed therefrom and the electronic components to be received therein, a plurality of vias, a second dielectric layer formed on the first dielectric layer and the electronic components and having a plurality of dielectric layer vias for the electronic components to be exposed therefrom and the vias to be formed therein, and a second circuit layer formed on the second dielectric layer and electrically connected to the electronic components through the vias.

US 2022/377911 A1 describes a component carrier intermediate product including a first electrically insulating layer structure; an at least partially uncured and patterned second electrically insulating layer structure having recesses, wherein the recesses are filled by an electrically conductive material; and a component carrier section arranged on the at least partially uncured and patterned second electrically insulating layer structure.

Against this background, the technical problem underlying the present invention is to provide an alternative, in particular an improved, component carrier, an alternative, in particular improved, method for manufacturing such a component carrier, and an alternative, in particular improved, package comprising a component carrier, by which in particular one or more of the several existing challenges due to increasing complexity and miniaturization of electronic components in component carriers in terms of heat removal, mechanical robustness, electrical reliability, and/or yield loss can at least partially be addressed, in particular when it comes to valuable embedded components like microprocessor chips which have to be connected electrically.

### SUMMARY OF THE INVENTION

With respect to the above, a component carrier, a method for manufacturing thereof and a package comprising a component carrier according to the respective independent patent claims are provided. Advantageous embodiments of the present invention are defined by the dependent patent claims, the description, and the figures. The wording of the claims is hereby made part of the description by express reference.

According to a first aspect of the present invention, a component carrier is provided comprising a stack having a stacking direction, wherein the stack comprises at least one electrically insulating layer structure and at least one electrically conductive layer structure, and further at least a first component and a second component embedded in said stack one above the other in said stacking direction with a cavity in between. The first component and the second component each comprise a component main surface facing towards said cavity and delimiting said cavity in stacking direction partially, wherein said cavity is filled with an electrically conductive paste.

A component carrier according to the present invention allows to realize thinner buildups with more than one component layer. The direct arrangement of the components one above the other with the cavity in between at least partially delimited by said components allows providing a component carrier with a small height. The space needed for embedding the components within the component carrier can be reduced. This allows providing a very compact component carrier by which miniaturization can be improved, in particular of electronic packages comprising at least one component carrier. In particular, embedded packages may be further miniaturized.

Further, a component carrier according to the present invention allows in a very easy manner to establish direct and straight electrical connections with a short path length between components, in particular between embedded components, wherein an electrical connection between at least two components may in particular be established via the electrically conductive paste by which the cavity in between said components is filled with. A component carrier according to the invention allows to establish reliable vertical or Z-axis interconnections, in particular direct and straight and therewith as short as possible interconnections, between components arranged one above the other in different layers.

Thereby, and/or due to the possible small height of the component carrier, the performance of electrical connections between the components within the component carrier may be improved. In particular, short paths from one component to the other may be realized. Thereby, inductances may be reduced. Also, parasitics may be reduced. In some cases, a reduced signal delay and improved overall speed of signal transfer may be achieved. This might in particular be advantageously in high-frequency applications.

A component carrier according to the present invention may further allow a better thermal management, wherein in some cases in particular the thermal resistance of the component carrier may be reduced.

The properties of the component carrier, in particular the electrical, the thermal and/or the mechanical properties, may be influenced and/or adjusted by the design of the cavity (particularly its size and shape) and/or the material properties of the electrically conductive paste the cavity is filled with. The cavity filled with the electrically conductive paste might act as a thermal drain, conducting heat away and may therewith contribute to the thermal management of the whole component carrier. The electrically conductive paste may also enhance mechanical stability of the component carrier, if chosen properly. It may in particular influence resistance to thermal shock and environmental stresses.

In summary, a component carrier according to the present invention allows further miniaturization while at the same time offering a high degree of flexibility in terms of adaptation to the various applications.

The stack in particular comprises a plurality of layer structures, wherein the stack in a preferred embodiment may comprise at least one electrically insulating layer and at least one electrically conductive layer structure.

For an easy establishment of an electrical connection, in particular for establishing a direct electrical connection, preferably in stacking direction (which might be a vertical direction) between the first component and the second component, the first component and the second component may in particular be arranged in the stack such that they are at least partially overlapping one to each other from a top view. They can also be arranged fully overlapping.

The first component and/or the second component may in particular comprise at least one electrically conductive structure, for example one or more pads, which is in particular facing to said cavity, wherein in a preferred embodiment, the components are relatively arranged to each other such that at least the respective electrically conductive structures (e.g., the pads) are overlapping sufficiently one to each other from a top view for establishing an electrical connection.

The main surfaces of the first component and the second component, delimiting said cavity in between may have a congruent surface shape. However, this is not mandatory, and they alternatively may have different surface shapes and sizes. Only a certain degree of overlapping for establishing the electrical connection is necessary.

In a preferred embodiment, the first component and the second component are arranged, in particular embedded in the stack such that a direct electrical connection in stacking direction, preferably in a vertical direction, can be established between the first component and the second component by the conductive paste filled in the cavity delimited at least partially by the first component and the second component.

The design of the cavity, in particular its shape/or size, may in particular be adjusted flexibly to the use case of the component carrier. This offers advantages, particularly in terms of design and performance. In particular, an electrical connection which might be established by the electrically conductive paste by which the cavity is filled can be precisely adapted to the respective application. For a good heat dissipation, for example, a larger cavity, in particular with a larger extension in a planar direction, may be formed. For establishing a precise signal connection, for example, a very small cavity can be provided to minimize electrical losses and to improve performance.

A component carrier according to the present invention is suitable to incorporate components with different pad terminations to Cu like Au, Ag, Ti without any special pretreatment like PVD or adhesion promoters. This allows a very flexible design of component carriers with at least two embedded components.

Hence, in at least one embodiment, the first component and/or the second component may comprise at least one pad termination for establishing an electrical connection from/to said component, wherein in particular at least one pad termination of the first component may be different from at least one pad termination of the second component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components.

In particular, a component carrier may be one of or may be configured as a printed circuit board (PCB), an interposer, in particular an organic interposer, and a substrate, in particular an IC (integrated circuit) substrate. A component carrier may also be a hybrid board combining different ones of the above-mentioned types of component carriers.

A component carrier may in particular comprise one or more stacks and/or sub-stacks, wherein each stack in particular may comprise a plurality of layer structures, preferably at least one electrically conductive layer structure, and/or at least one insulating layer structure.

In at least one embodiment, the component carrier is in particular a laminate-type component carrier. In such an embodiment, the component carrier may in particular be a compound of multiple layer structures which are stacked and connected together by applying a pressing force and/or heat.

In the context of the present application, the term "stack" may particularly denote an arrangement of multiple layer structures which are preferably planar and mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "stacking direction" my particularly refer to a direction perpendicular to a planar extension of at least one layer structure of the stack.

In the context of the present application, the term "layer structure" may particularly denote a continuous layer, a patterned layer or a plurality of non-consecutive islands within a common plane.

In at least one embodiment, at least one body and/or layer structure and/or component of the component carrier comprises a main surface, wherein in the context of the present application, the term "main surface" of a body or a layer structure or a component may particularly denote one of the two largest opposing surfaces of the body or the layer structure or the component. The main surfaces may be connected by circumferential side walls. The thickness of a body, such as component, a stack or sub-stack, or a layer structure may be defined by the distance between the two opposing main surfaces.

In the context of the present application, the term "electrically conductive layer structure" may particularly denote a layer structure which is electrically conductive. An electrically conductive layer structure may in particular comprise one or more conductive pathways, tracks, and/or signal traces. These electrically conductive structures may for example be etched from copper sheets and may, for example, be laminated onto an electrically non-conductive or electrically insulating layer structure.

In at least one embodiment, the at least one electrically conductive layer structure of the component carrier comprises at least one of the following group consisting of: copper, aluminum, nickel, silver, gold, palladium, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT), respectively. In an example, the electrically conductivity of the electrically conductive layer structure may be larger than 5*10^4 S/m, in particular larger than 10^6 S/m.

In the context of the present application, the term "electrically insulating layer structure" may denote a layer structure which is electrically non-conductive.

In at least one embodiment, at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "component" may particularly denote an electronic component which is in general configured to be mounted on and/or to be embedded into a component carrier, wherein the component may further in particular be configured to be electrically connected to the component carrier.

The at least one component may be selected from a group consisting of: an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (AI2O3) or aluminum nitride (AIN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. A component may in general be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "cavity" may particularly denote a recess or hollow space having been created within the structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. In addition or alternatively, an etching process may be used to create at least one cavity of the component carrier at least partially. At least one cavity may have been created by assembling at least two parts of a cavity to a common cavity, wherein each part of said common cavity may have been created least partially or completely as described above. In an example, the cavity may be filled at least partially with electrically conductive material, for example with material for or of an electrically conductive layer structure or with material forming at least partially an electrically conductive layer structure, and/or with electrically insulating material, for example with material for or of an electrically insulating layer structure or with material forming at least partially an electrically insulating layer structure. In another example, at least a part of the cavity may be free of an electrically conductive layer structure and/or may be free of an electrically insulating layer structure.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy.

In at least one embodiment, in particular in a preferred embodiment of a PCB, the PCB is in particular formed by laminating several electrically conductive layer structures with several electrically insulating layer structures. At least one insulating layer structure may in particular be arranged at least partially in between two electrically conductive layer structures and/or adjacent to and/or surrounding at least one electrically conductive layer structure.

As preferred materials for PCB technology, the electrically conductive layer structures may be made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack or sub-stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A dielectric part of a substrate may be composed of resin with reinforcing particles (such as reinforcing spheres, in particular glass spheres). A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates.

A substrate or interposer may in particular comprise or consist of at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole.

In at least one embodiment, the component carrier may further comprise at least one inorganic layer structure, wherein said at least one inorganic layer structure may in particular be part of at least one stack of said component carrier.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS2, CuGaO2, AgAlO2, LiGaTe2, AglnSe2, CuFeS2, BeO.

In at least one embodiment, in particular in a preferred embodiment, the first component and the second component are electrically connected with each other by said electrically conductive paste.

Thereby, in a very easy manner a direct electrical connection between the first component and the second component can be established within the component carrier, wherein in particular a very short and straight electrical connection can be established with the advantages described above.

In at least one embodiment, in particular in a preferred embodiment, at least the first component and the second component are directly and/or exclusively connected by the (electrically conductive) paste.

In the context of the present application the expression "directly and/or exclusively connected" may in particular denote a connection which is being established without an intermediate portion of an electrically conductive layer structure in between.

This allows to establish a component carrier with at least two components being electrically connected with the shortest possible electrical connection (by a straight lined connection). With an electrical connection like this, in particular due to the short path length, the advantages described above may be achieved. In particular, advantageous electrical performance may be achieved. In some cases, for example, in particular electrical losses, inductances, and parasitics may be reduced. By adaptation of the design of the cavity, in particular of its size and shape and/or by the choice of the conductive paste, in particular its material properties, the thermal properties of the component carrier may be influenced and/or adjusted, in particular at least in the connection zone of the components. As a result, inter alia, for example, heat dissipation may be influenced advantageously.

As mentioned above, at least one cavity of the component carrier according to the present invention may be created at least partially by a mechanical manufacturing step as for example laser drilling and/or mechanical drilling. In particular, when the cavity is created at least partially by laser drilling and/or a mechanical drilling, this may result in a cavity comprising a lateral wall which is at least partially tapered. Hence, in at least one embodiment, the cavity may comprise a tapered lateral wall.

In the context of the present application the term "tapered" may in particular denote an at least partial inclination to the stacking direction and/or to the main surface of at least one of the components limiting said cavity.

That means in other words, a tapered lateral wall may in particular be a wall, which is at least partially inclined to the stacking direction and/or to the main surface of at least one of the components limiting said cavity.

The inclination of the tapered lateral wall may be constant over the height of the cavity or may vary. As a result, in one embodiment of a component carrier according to the present invention, a cavity comprising a tapered lateral wall may in a cross-section in a plane parallel to stacking direction of said cavity in particular appear as a cavity having at least partially an at least substantially trapezoidal shape. In another embodiment, a cavity comprising a tapered lateral wall may in a cross-section in a plane parallel to stacking direction of said cavity in particular appear as a cavity having at least partially an at least substantially hexagonal shape, preferably the shape of a stretched or extended hexagon.

This design of the component carrier allows to provide a component carrier with a small height which can further be easily manufactured.

In at least one embodiment, the cavity is further partially delimited in lateral direction by at least one layer structure of said stack. The cavity may in particular be partially delimited by the same layer structure the cavity may have been at least partially created in, wherein the cavity may in particular at least partially be formed by a recess within said layer structure. The cavity may also be delimited at least partially by one or more different and separate layer structures surrounding said cavity.

In at least one embodiment, in particular in a preferred embodiment, and in addition, to the limitation by the components, which delimit the cavity partially in particular in stacking direction (in particular one from the top side and one from the bottom side), the cavity may in particular also be delimited partially by at least one layer structure of the stack, in particular in stacking direction and/or in lateral direction, preferably in a lateral direction extending perpendicular to the stacking direction.

In other words, in at least one embodiment of component carrier said cavity may be delimited partially in stacking direction by one of the main surfaces of the first component, by one of the main surfaces of the second component and by at least one layer structure of said stack, wherein the cavity may in particular be delimited by said layer structure also in stacking direction and/or in a lateral direction, in particular in a lateral direction extending perpendicular to the stacking direction.

This design of the component carrier allows to provide a component carrier with a small height which can further easily be manufactured.

In at least one embodiment, the cavity is in particular partially delimited by a first electrically insulating layer structure. In particular, the cavity may also be delimited partially by several insulating layer structures which may in particular limit the cavity as already described above in stacking direction and/or in lateral direction, in particular in a lateral direction perpendicular to the stacking direction.

This design of the component carrier allows to provide a very compact component carrier with a small height which can further be easily manufactured.

In at least one embodiment, the cavity is delimited in its entirety by the first component, the second component and the first electrically insulating layer structure only, wherein the first component and the second component particularly delimit the cavity in stacking direction and the first insulating layer structure preferably delimits the cavity in direction of the main extension of the component carrier and/or the components respectively. The first insulating layer structure may in particular delimit the cavity at least partially in a direction perpendicular to the stacking direction.

This design allows providing of a very compact component carrier with a very small height which can be manufactured very easily and very efficiently. However, in some cases another design of a component carrier may be more advantageous in which the cavity is not only delimited by the first component, the second component and the first electrically insulating layer structure.

In at least one embodiment, in particular in a preferred embodiment, the component carrier, in particular the stack, may comprise at least one sub-carrier. In the context of the present application, the term "sub-carrier" may in particular denote a structural element supporting the main carrier function of the component carrier. A sub-carrier may form a part of a layer structure or a complete layer within a stack. A sub-carrier may in particular have a specific function, in particular the function to mechanically strengthen the component carrier.

In at least one embodiment, the component carrier comprises a first sub-carrier and a second sub-carrier, stacked one above the other in stacking direction. This may increase the design flexibility of the component carrier.

In at least one embodiment, in particular in a preferred embodiment, at least one component of the component carrier may be embedded in a sub-carrier (at least partially or completely), wherein in particular the first component and/or the second component may at least partially be embedded in a sub-carrier. This design of a component carrier allows providing of a very compact component carrier which can further easily be manufactured, and which may further comprise advantageous mechanical properties.

In at least one embodiment, the first component being at least partially embedded in the first sub-carrier, and the second component being at least partially embedded in the second sub-carrier.

In at least one embodiment, in particular in a preferred embodiment, at least one sub-carrier may comprise a sub-carrier main surface facing towards said cavity, wherein the cavity may in particular also be partially delimited in stacking direction by at least one sub-carrier main surface.

This design of a component carrier allows providing of a very compact component carrier which can further easily be manufactured and may comprise advantageous mechanical properties.

In at least one embodiment, the first sub-carrier and the second sub-carrier each comprise a sub-carrier main surface facing towards said cavity, wherein the cavity is in particular also partially delimited in stacking direction by at least one of the sub-carrier main surfaces.

In at least one embodiment, in particular in a preferred embodiment, the cavity may in particular partially be delimited by the sub-carrier main surface of the first sub-carrier and/or (preferably and) by the sub-carrier main surface of the second sub-carrier.

In at least one embodiment, in particular in a preferred embodiment, at least one component may be at least partially embedded in one of the sub-carriers such that its component main surface is being exposed facing the other sub-carrier, wherein the exposed component main surface may particularly delimit the cavity.

This allows establishing a direct electrical connection between the first component and the second component, wherein the component carrier may still easily be manufactured and may comprise advantageous mechanical properties.

In at least one embodiment, the first component is at least partially embedded in the first sub-carrier such that its component main surface is being at least partially exposed and facing the second sub-carrier, wherein said exposed component main surface of the first component delimits said cavity partially, and wherein the second component is at least partially embedded in the second sub-carrier such that its component main surface is being at least partially exposed and facing the first sub-carrier, wherein said exposed component main surface of the second sub-carrier delimits said cavity partially.

This design of a component carrier allows providing of a very compact component carrier which can further easily be manufactured. This design allows in particular providing a component carrier having a small height and components being electrically connected along short electrical connection paths, since no unnecessary parts or structures are arranged in between the two components.

In at least one embodiment, the first electrically insulating layer structure is or composes at least partly an intermediate electrically insulating layer structure being provided in stacking direction between the first sub-carrier and the second sub-carrier.

In the context of the present application, the term "intermediate" may in particular denote to a layer structure within the stack that is neither the topmost nor the bottommost layer.

Thereby, in particular by said intermediate electrically insulating layer structure, in an easy and space saving manner the necessary electrical insulation between the two components outside of the cavity and/or the electrically conductive paste, respectively, can be achieved.

In at least one embodiment, the intermediate electrically insulating layer structure comprises a recess at least partially delimiting said cavity, in particular in a lateral direction, preferably in a direction perpendicular to the stacking direction.

In at least one embodiment, the cavity may in particular be delimited by the first component, the second component and by the first electrically insulating layer structure in its entirety, in particular by the intermediate electrically insulating layer structure. In other embodiments the cavity may also be partially delimited by at least one other structure, in particular by at least one other layer structure, preferably by at least one other electrically insulating layer structure. In some embodiments the cavity may also be partially delimited by at least one electrically conductive layer structure.

This allows providing of a component carrier comprising one or more of the advantages described above, and which may be flexibly adapted to several use cases, in particular with respect to the required layer structures and electrical connections within the component carrier.

In at least one embodiment, in particular in a preferred embodiment, at least one sub-carrier may comprise a core structure layer, wherein the core structure layer may in particular comprise at least one cavity, in which preferably at least one component may be embedded, in particular at least one of the components partially delimiting the cavity being filled with electrically conductive paste.

Hence, in at least one embodiment, in particular in a preferred embodiment, at least one sub-carrier comprises a core structure layer, the core structure layer comprising at least one cavity, wherein in said at least one cavity at least one component is embedded, preferably the first component or the second component.

In at least one embodiment, in particular in a preferred embodiment, the first sub-carrier may comprise a first core structure layer comprising a first cavity, in which in particular the first component is embedded. Alternatively or in addition, the second sub-carrier may comprise a second core structure layer comprising a second cavity, in which in particular the second component is embedded. Thereby, the core structure layer may in particular form or be a mechanically stiffening layer structure. This allows to embed at least one component in a layer structure having a certain mechanical strength to support the protect the component at least partially mechanically.

In at least one embodiment, in particular in a preferred embodiment, at least one sub-carrier may comprise a first external insulating layer structure, which may in particular be provided on an external side of said sub-carrier, wherein said first external insulating layer structure may preferably be provided on the external side of said sub-carrier facing towards the cavity. Thereby, said first external insulating layer structure may in particular partially composing said intermediate electrically insulating layer structure.

In at least one embodiment at least one component is embedded such in said sub-carrier that the component's main surface facing towards said cavity being filled with the conductive paste is on a different (vertical) level in stacking direction than the main surface of the core structure layer on its cavity facing side of said sub-carrier and/or than the main surface of said sub-carrier on its cavity facing side. That means in other words that in at least one embodiment at least one component may be embedded such in said sub-carrier that its main surface facing towards said cavity is not in flush with the main surface on the cavity facing side of the core structure layer and/or the sub-carrier the component is embedded into.

The main surface of the component may in particular be protruding in stacking direction from the vertical level of the main surface of the core structure layer and/or the sub-carrier it is embedded into. This may be achieved, for example, with a component carrier having a height in stacking direction being larger than a layer thickness of the core structure layer and/or the sub-carrier and/or with a component arranged onto a distance layer structure arranged in said cavity beneath said component and on the component's side facing away from the part of said cavity being filled with the conductive paste.

Alternatively, the main surface of the component may in stacking direction in particular be below the vertical level of the main surface of the core structure layer and/or the sub-carrier it is embedded into. This may be achieved, for example, with a component carrier having a height in stacking direction being smaller than a layer thickness of the core structure layer and/or the sub-carrier.

Even with such a design with the main surface of the component not flushing with the main surface of the core structure layer and/or with the main surface of the sub-carrier on the cavity facing sides, the present invention allows establishing a proper connection of the component at its connection surface in a very efficient manner because the different vertical levels may in particular be leveled, compensated and/or bridged by the conductive paste.

Hence, in at least one embodiment, at least one sub-carrier comprises a first external insulating layer structure, said first external insulating layer structure being provided on the external side of said sub-carrier facing towards the cavity and partially composing said intermediate electrically insulating layer structure.

This allows to provide a very compact component carrier.

In at least one embodiment, the first sub-carrier and the second sub-carrier may each comprise a first external insulating layer structure, wherein said first external insulating layer structures may each being provided on the external sides of said sub-carriers facing towards the cavity and each partially composing said intermediate electrically insulating layer structure, wherein at least one first external insulating layer structure may be provided on the external side of the core structure layer of the respective sub-carrier.

In an alternative embodiment, only the first sub-carrier or the second sub-carrier may comprise such a first external insulating layer structure. Thereby, the height of the component carrier, in particular of the respective stack of said component carrier, may be further reduced.

In at least one embodiment, at least one sub-carrier may comprise a second external insulating layer structure, in particular being provided on an opponent side of said sub-carrier, wherein "on an opponent side" in particular may denote in the context of the present application on an opponent side of the side on which the first insulating layer structure is provided.

Such a second insulating layer structure may in particular be advantageous in some cases, in particular for realization of several (electrical) functions.

In at least one embodiment, a portion of the first external insulating layer structure and/or the second external insulating layer structure extends into a space between the component and a lateral wall of said core structure layer delimiting the component cavity, in particular in lateral direction, wherein said space into which said portion may be extend is in particular a lateral space being formed in a direction perpendicular to the stacking direction between the embedded or to be embedded component and a lateral wall of said core structure layer laterally delimiting the cavity in which the component is embedded or to be embedded.

By said portion, in an easy manner the space between the embedded or to be embedded component in the cavity of the core structure layer can be filled to ensure sufficient embedding of the component.

In at least one embodiment, at least one of the external insulating layer structure is in contact with a main surface of said core structure layer, with one main surface of a component and with the other external insulating layer.

In particular, both external insulating layers (i.e., the first external insulating layers and the second external insulating layers) may be in contact with one main surface of said core structure layer, with one component main surface and with the other external insulating layer.

In at least one embodiment, in particular in a preferred embodiment, the first external insulating layer and the second external insulating layer are in contact with one main surface of said core structure layer, with one component main surface and with the other external insulating layer, wherein this may in particular be realized via at least one portion extending into the space between the component and a lateral wall of said core structure layer. In particular the contact between said two external insulating layer structures may be established by at least one portion extending into said lateral space in between the component and the lateral wall of the core structure layer.

This allows a sufficient embedding of at least one component with simultaneous, simple realization of the required electrical insulation.

In at least one embodiment, at least one component flushes with one of the core structure layer main surface such that one of said first of second external insulating layer structure is in contact with said component main surface and said core structure layer main surface, thus contacting at least two surfaces, in particular said component main surface and the corresponding core structure layer surface, flushing to each other.

In a preferred embodiment, at least one main surface (in particular the exposed one) of a component or of an outer material (surface) of a pad of the component flushes with one of the core structure layer main surfaces such that one of said first or second external insulating layer structure is in contact with said component main surface and said core structure layer main surface, thus contacting at least two surfaces, in particular said component main surface and the corresponding core structure layer surface, flushing to each other.

This allows to provide a very compact component carrier while at the same time ensuring reliable integration of the component.

In at least one embodiment, said portion of one of the first or the second external insulating layer structures extends into said space between the component and a lateral wall of said core structure layer, in particular delimiting the component cavity in lateral direction, such that said portion flushes with at least one component main surface and one of the core structure layer main surfaces, wherein in particular the other one of said first or second external insulating layer structures is in contact with said portion, wherein said component main surface and said core structure layer main surface are flushing one to each other.

This may, in some embodiments, result in a flat surface of the first external insulating layer structure facing the exposed component. In other embodiments, the surface facing the exposed component of the first external insulating layer structure may be not flat, for example due to the presence of an electrically conductive structure on the surface of the core. In this case, the surface facing the exposed component of the first external insulating layer structure may particularly follow the profile defined by the core structure layer and the overlapping conductive structure.

In at least one embodiment, in particular said component main surface, the corresponding core structure layer surface, and also said portion extending into the lateral space are flushing with each other.

In at least one embodiment, said component main surface, the corresponding core structure layer surface and said portion extending into the lateral space may form further internal surfaces of the stack facing the other component, in particular the other sub-carrier comprising the other component.

This design allows an easy manufacturing of the component carrier, in particular an advantageous embedding and electrical connection of said components and simultaneously realizing the required electrical insulation.

In at least one embodiment, the stack comprises at least a first sub-stack and a second sub-stack, stacked one above the other in stacking direction.

This allows providing of a component carrier which can be manufactured in a very easy manner, wherein in at least one embodiment the stack of the component carrier according to the present invention is formed by stacking the first sub-stack and the second sub-stack one above the other in stacking direction.

Thereby, at least one sub-stack may encompass at least one component, in particular the first component or the second component.

In at least one embodiment, in particular in a preferred embodiment, the first sub-stack encompasses the first component, and the second sub-stack encompasses the second component.

This allows a very easy manufacturing of the component carrier, in particular a very easy forming of the stack with the cavity filled with electrically conductive paste in between and being delimited at least partially by the first component and the second component.

In at least one embodiment, at least one sub-stack further encompasses a part of the cavity between the first component and the second component in stacking direction.

In a preferred embodiment, the first sub-stack comprises a first part of said cavity, and the second sub-stack comprises a second part of said cavity, wherein the cavity in its entirety is in particular formed by stacking one above the other of the first sub-stack and the second sub-stack.

This design allows in a very easy manner filling the cavity with electrically conductive paste when forming the stack, and therewith also in a very easy manner to establish an electrical (inter-)connection of the first component and the second component.

In at least one embodiment, the first sub-stack further encompasses the first sub-carrier, and wherein the second sub-stack further encompasses the second sub-carrier, wherein in particular the first component is at least partially embedded in the first sub-carrier, and wherein the second component is in particular at least partially embedded in the second sub-carrier.

This design allows a very efficient and easy manufacturing of the component carrier according to the present invention having the advantages described above.

In at least one embodiment, at least one sub-stack further comprises at least a first external insulating layer structure, said first external insulating layer structure in particular forming at least a part of the intermediate layer structure.

By providing at least one sub-stack comprising at least a first external insulating layer structure, which in particular forms at least a part of the intermediate layer structure of the final stack, allows to integrate an (intermediate) insulating layer structure in between the corresponding component layers in a very easy manner. Further, and also in a very easy manner the cavity filled with electrically conductive paste may be electrically insulated at least in lateral direction by said intermediate insulating layer structure, which is essential for proper functioning of an electrical connection between the first component and the second component via the electrically conductive paste.

In at least one embodiment, the first sub-stack and the second sub-stack each comprising a main surface facing towards each other, and in particular being connected via their main surfaces facing to each other.

This design of the component carrier allows in a very easy manner establishing a direct electrical connection between the first component and the second component, in particular with a very short electrical connection path length, resulting in advantageous electrical performance.

For establishing at least one further electrical connection of the component carrier, for example with an external part, and/or with at least one of the components, for example with an external part and/or another internal a part of the component carrier, the component carrier may further comprise at least one electrically conductive structure which may in particular be part of at least one sub-stack, in particular of at least one sub-carrier. Thereby, at least one electrically conductive structure may in particular be provided on and/or in the core structure layer of a respective sub-carrier, wherein the electrically conductive structure may in particular be plated. At least one electrically conductive structure may be a layer (i.e., a substantially two-dimensional structure) or a conductive structure, for example a three-dimensional structure, as a vias for example. For proper function of said conductive structure, preferably at least one electrically insulating layer structure, in particular at least one external insulating layer structure, is in contact with said conductive structure, wherein to be in contact, the insulating layer structure preferably extends to the conductive structure.

In at least one embodiment, in particular preferred embodiment, at least one sub-carrier comprises at least one plated electrically conductive structure being provided on and/or in the core structure layer of said sub-carrier for establishing an electrically connection between at least a first element of said component carrier and at least a second element, wherein preferably said first external insulating layer structure of said core structure layer is in contact with said electrically conductive structure and the core structure layer.

This allows in an easy manner providing a component carrier which is configured for establishing an electrically connection between at least a first element of said component carrier and at least one second element, wherein the second element may be an internal element of the component carrier or an external element not being part of the component.

This allows a flexible design of component carrier and providing a component carrier configured with a wide range of applications, wherein the component carrier may in particular be adapted flexibly to different applications.

In at least one embodiment, each sub-stack, in particular each sub-carrier of said sub-stack, comprises at least one plated electrically conductive structure, wherein in particular said sub-stacks, preferably the sub-carriers, are connected one to each other by one or more plated electrically conductive structures. At least one plated electrically conductive structure may be a three-dimensional plated structure, for example a vias.

Thereby, advantages electrical connections can be provided between said substates, in particular between said sub-carriers.

Plated connections may in some cases be more advantageous than electrical connections established via electrically conductive paste.

However, in at least one embodiment of a component carrier according to the present invention, the component carrier may further comprise at least one further electrical connection being established via an electrically conductive paste.

In at least one embodiment, in particular in a preferred embodiment, the component carrier further comprises at least one alignment structure for alignment of at least two parts of the component carrier relatively to each other, in particular during manufacturing, for proper manufacturing of said component carrier.

By such an alignment structure, for example, the first component and the second component can be aligned relatively to each other when being stacked one above the other in order to ensure sufficient overlapping for establishing a straight and direct electrical connection, in particular and second direction.

In at least one embodiment, the component carrier further comprises at least one alignment structure being provided on and/or in at least one sub-carrier, in particular on and/or in at least one sub-stack, at least partially.

The provision of at least one alignment structure on and/or in at least one sub-stack, in particular on and/or in at least one sub-carrier allows improved alignment.

In at least one embodiment, at least one alignment structure may comprise or be a hole, a conductive pattern and/or a pad or a combination thereof. In another embodiment, an alignment structure may comprise or be formed of a plurality of holes or recesses and/or a non-conductive pattern or combinations thereof, in particular alternatively or in addition to the options mentioned above. For providing a compact component carrier, in particular with a small height, thin alignment structures and/or alignment structures with a small height and/or alignment structures later being embedded and not increasing the overall stack or component carrier height are preferred. Preferably, at least one structure being anyway present in the component carrier, also serves as alignment structure. In particular conductive and/or non-conductive structures, traces, pads, and/or shapedcodes may also serve as alignment structures in addition to their original function. Also so-called "fiducial marks" may be used for alignment.

This allows providing of at least one alignment structure without addition of any further component to the component carrier, which is advantageous, in particular with respect to miniaturization.

In at least one embodiment, at least one alignment structure is configured for an alignment of the intermediate layer and/or the alignment of the paste and/or the alignment of a sub-carrier and/or the alignment of a sub-stack and/or combinations thereof and/or an alignment of at least two of them relatively to each other.

Thereby, in an easy manner an advantageous alignment can be achieved.

A component carrier may comprise one or more alignment structures, in particular at least one alignment structure for every process step in which an alignment is necessary. This allows an efficient and precise manufacturing of the component carrier.

In at least one embodiment, at least two components being stacked one above the other in the component carrier, in particular at least the first component and the second component, may be stacked one above the other with a defined lateral shift in lateral direction relative to each other.

In the context of the present application, the term "lateral shift" may denote a distance in lateral direction between the geometrical centers in lateral direction of two elements, in particular of two elements of the component carrier stacked above each other.

In at least one embodiment, at least one component may on its main surface side, which is facing towards said cavity further electrically be connected to a further electrically conductive structure, in particular to an electrically conductive structure being provided on and/or in the core structure layer of a sub-carrier facing towards said main surface of said component. For example, said component may be electrically connected to a vias and via said vias, for example, with an electrically conductive structure on a main surface of a sub-carrier and/or a core structure layer, which is facing towards said component.

This allows to enable additional connections of the component on the cavity facing side of the component with other elements. Thereby, the design flexibility of the component carrier and/or its connection density may be increased. This may enhance miniaturization.

In at least one embodiment, the component carrier may further comprise at least a third component.

In at least one embodiment, said third component is also embedded in said stack and being stacked with the first component and/or the second component in stacking direction with a cavity in between, in particular with an additional or separate cavity in between, wherein the third component in particular also comprises a component main surface facing towards said cavity and delimiting said cavity in stacking direction partially, and wherein said cavity is in particular filled with an electrically conductive paste.

This allows to arrange and/or connect the first component and/or the second component with a further component in a very compact and space saving manner within a component carrier and/or within a stack of the component carrier. Thereby, the design flexibility and/or the functionality of the component carrier may be increased, in particular in a very space saving manner. In some embodiments also connection density may be increased. This may enhance miniaturization.

In at least one embodiment, the third component is electrically connected with at least one of the first and the second components, in particular via the respective cavity being filled with electrically conductive paste. This allows to connect several components within a component carrier and/or in a stack of said component carrier with each other in a very compact and space saving manner. Thereby, the design flexibility and/or the functionality of the component carrier may be increased, in particular in a very space saving manner. In some embodiments also connection density may be increased. This may enhance miniaturization.

In at least one embodiment, the third component may be embedded in the same layer structure, in particular in the same sub-carrier, as the first component or the second component, wherein the third component may in particular be embedded in the same sub-carrier and/or core structure layer of that component it is not connected with. This allows to arrange several components within a component carrier and/or within a stack of said component carrier in a very compact and space saving manner. Thereby, the design flexibility and/or the functionality of the component carrier may be increased, in particular in a very space saving manner. In some embodiments also connection density may be increased. This may enhance miniaturization.

In at least one embodiment, wherein the first component, the second component, and the third component may be electrically connected with each other, wherein one of the components may in particular act as a bridge and may in particular be configured for bridging at least one signal from one component to the other, in particular from one component of the other two components to the other one of said two components. This allows to arrange and connect several components (at least three components) within a component carrier and/or within a stack of a component carrier in a very compact and space saving manner. Thereby, the design flexibility and/or the functionality of the component carrier may be increased, in particular in a very space saving manner. In some embodiments also connection density may be increased. This may further enhance miniaturization.

A component carrier according to the present invention allows in particular to embed several components with a high flexibility regarding their arrangement within the component carrier and/or within a stack with a high amount of possible connection possibilities in a very compact and space saving manner. At least in some embodiments, connection density may be increased, and miniaturization may be enhanced.

A component carrier according to the present invention may also allow to embed components of different sizes and/or different types of components. In at least one embodiment, at least two components may be of a different type providing different functionality. Thereby, the design flexibility and/or the functionality of the component carrier may be increased.

In at least one embodiment, at least two components may have the same length or different lengths in lateral direction, and/or the same height or different heights in lateral direction, in particular in a direction perpendicular to the stacking direction. A component carrier allows to embed components of different sizes. Thereby, the design flexibility and/or the functionality of the component carrier may be increased, in particular in a very space saving manner. In some embodiments also connection density may be increased. This may enhance miniaturization.

In at least one embodiment the first component and the second component each comprises a pad, said pads in particular facing the cavity in between the components which is filled with the conductive paste, wherein each pad has a pad area with a pad area size, wherein said pads are provided one above the other in stacking direction and opposed to each other in order to overlap, and wherein the pads are aligned to each other such that their pad areas are overlapping with at least 50% of the pad area size of the smaller one of the overlapping pads. This ensures in a very easy manner the establishment of reliable mechanical and/or electrical connections between said pads and thus also between the components.

This allows to connect the first component and/or the second component with a further component in a very compact and space saving manner. Thereby, the design flexibility and/or the functionality of the component carrier may be increased, in particular in a very space saving manner. In some embodiments also connection density may be increased. This may enhance miniaturization.

In at least one embodiment, the first component and the second component each comprise a pad, said pads being provided one above the other in stacking direction and opposed to each other in order to overlap, in particular with respect to a lateral direction perpendicular to the stacking direction, wherein the pads are aligned to each other, in particular by at least one alignment structure.

In the context of the present application the term "pad" may in particular denote a small, flat structure being configured to serve as a contact point for replacing or electrically connecting at least one component. Such a pad may in particular consist or be made of copper to ensure good electrical conductivity. A pad may in particular be plated with solder or similar metal to facilitate soldering of at least one component with said pad to establish an electrical connection with said pad.

In particular said pads (and/or other analogous structures of the component being provided for establishing a connection, in particular an electrical connection, with the component) are aligned such that a deviation (i.e., a lateral shift or offset, in particular in a direction perpendicular to stacking direction) of ideal overlapping does not exceed a defined limit.

The limit may in particular be defined in percent with respect to the size, in particular with respect to the dimension or lateral extension of the connection structure, for example with respect to a pad size in lateral direction (i.e., in particular in a direction perpendicular to stacking direction). Preferably, the smallest connection structure of the respective overlapping connection structures defines the base size. The (allowed) deviation (i.e., the allowed lateral shift) of said pads (or said respective connection structures) stacked one above the other may in particular be in a range from 0,001% to 20% based on the smallest extension of the overlapping components in lateral direction. Preferably, the deviation is in a range from 0,001% to 10%, more preferably in a range from 0,001% to 5%, and most preferably in a range from 0,001% to 2% based on the smallest extension of the overlapping components in lateral direction. That means in other words, if the smallest extension of a first pad and a second component in lateral direction, in particular in a lateral direction perpendicular to stacking direction, is for example 150 µm, that with an allowed deviation (shift) of 10% the maximum allowed lateral side shift between the first pad and the second pad, in particular of their geometric center points in said lateral direction, may be 15 µm for establishing a proper electrical connection.

However, in some cases a maximum deviation of 60 µm, 30 µm, 10µm or even 5 µm might be more appropriate than a maximum deviation indicated in percent as defined above.

It has to be noted that the deviation or lateral shift between two connection pads on different vertical levels, which must not be exceeded in order to ensure proper electrical connection between said pads, must not be mixed-up with the lateral shift of the components the pads may belong to. Two components may be arranged, for example, with a lateral shift of 100 µm, however, their connection pads have to be arranged such on the respective components and relatively to each other that proper overlapping of said pads within the admissible deviation or lateral shift of, for example 10 µm, between said pads is ensured. This may be achieved by proper positioning of the pads on the components, if necessary, with respect or considering the lateral shift of the corresponding components.

This enables the establishment of a direct connection of the first component and the second component, in particular of a straight direct connection, preferably of at least substantially the shortest possible direct and straight connection in stacking direction.

In at least one embodiment, the first component and the second component each being at least partially embedded in a sub-stack, in particular in a sub-carrier, said sub-stacks, in particular the respective sub-carriers of said stacks, being provided one above the other in stacking direction and being particularly arranged opposed to each other such that the first component and the second component, in particular their pads, are facing towards each other and further in particular such that they are at least partially overlapping in stacking direction, preferably to allow the establishment of a connection between said components, in stacking direction, wherein they may in particular being aligned to each other by at least one alignment structure.

Thereby, an advantageous component carrier may be provided. Additionally or alternatively, this may ensure a short distance between the first component and the second component resulting in better electronic and thermal properties, in particular in reduced electrical losses and/or improved heat dissipation.

In at least one embodiment, at least one of the first external insulating layer structures and/or said intermediate electrically insulating layer structure, which in particular delimit the cavity being filled with the electrically conductive paste at least partially, comprises a plurality of layer structures, in particular exactly two layer structures.

Thereby, a very compact component carrier with a low number of layers may be provided, but which still enables sufficient functionality.

In at least one embodiment, at least two layer structures of said first external insulating layer structures and/or said intermediate electrically insulating layer structure are in contact to each other along a contact surface at least partly, optionally completely, wherein said at least two layer structures are in particular at least partially connected along said contact surface to each other.

Thereby, a very compact component carrier with a low number of layers may be provided, but which still enables sufficient functionality.

In at least one embodiment, at least one electrically conductive structure of the component carrier is provided at said contact surface, in particular in between said two layers, preferably in a contact zone.

Thereby, in an easy manner a component carrier may be provided which is configured for establishing at least one further internal connection and/or at least one external connection.

In at least one embodiment, at least one electrically conductive structure partially delimits the cavity, in particular a conductive layer structure provided on the exposed main surface of the component facing towards the cavity.

This design allows providing and/or efficient manufacturing of an advantageous component carrier.

In at least one embodiment, at least one electrically conductive layer structure is electrically connected to at least one pad of the first component or of the second component, in particular by the conductive paste, but preferably to none of the pads of the other component.

This may bring the advantage of establishing the connection of one of the components selectively.

In at least one embodiment, at least one electrically conductive layer structure is provided such that it contacts the conductive paste at its lateral side and/or penetrates into the conductive paste from the lateral side of said cavity.

This may bring the advantage of having higher design flexibility and electrically connecting one component only, in particular selectively.

In at least one embodiment, on the main surface of the first component and/or the second component, nanowires are provided. They may also be provided on a third component or further parts of the component carrier.

In the context of the present application, the term "nanowires" may in particular denote a pool of wires having a wire diameter in the nanometer range, wherein the wires may be arranged structured, in particular regularly, or unstructured, in particular irregularly or chaotic. Nanowires may in particular comprise metal atoms, for example copper and/or silver, silicon or other material and/or combinations thereof. Nanowires may preferably be configured for enabling electrical conductivity and/or be electrically conductive. Due to their nanoscale dimensions, nanowires usually have a high surface-to-volume ratio, which may significantly affect their physical properties, in particular advantageously.

With nanowires better adhesion and/or electrical conductivity between the component and the paste may be achieved.

In at least one embodiment, in addition or alternatively to the main surface of at least one component, on one or more other surface of the stack nanowires may be provided (as long as this does not have disadvantageous and does not cause a short, for example).

In at least one embodiment, the cavity is in addition filled partially with other material than with an electrically conductive paste, in particular with solder material, and/or at least one spacer, for example one or more copper blocks or one or more ceramic blocks.

This, in particular providing at least one spacer between the components, may bring the advantage of providing a component carrier having a constant and/or predefined distance between the components. Using a copper block, for example, may also enhance heat transmission between the components and there with heat dissipation capabilities of the component carrier.

This design of a component carrier according to the present invention not only allows to provide a component carrier having a constant distance between the components within said component carrier, but also allows to manufacture component carriers reliably and in a very easy manner with a defined distance between the components.

In at least one embodiment, the component carrier comprises at least one further cavity, also filled with an electrically conductive paste, said paste electrically connecting at least to conductive layers structures and/or two components and/or two sub-carriers and/or two sub-stacks with each other.

The electrically conductive paste said one further cavity might be filled with may in particular be the same conductive paste as the cavity between the first component and the second component is filled with or a different one.

By the at least one further cavity being filled with electrically conductive paste a further electrical interconnection within said component carrier may be established in a very easy manner.

In at least one embodiment, at least one cavity of the component carrier is filled with a solder paste and/or sinter paste. Said may in particular comprise electrically conductive particles in the range of 500 nm to 30 µm.

In at least one embodiment, the electrically conductive paste may comprise copper, tin, silver and/or bismuth.

In at least one embodiment, in particular in a preferred embodiment, at least one cavity may be filled with a lead-free paste, in particular, for example, with lead-free paste Ormet^{®} 701 by Ormet Circuits, Inc. or the like. The aforementioned Ormet^{®} 701 electrically conductive paste is, for example, specifically designed to fill micro-via structures, thereby creating Z-axis interconnections between several layers in packages and component carriers. By the use of such a paste, yield may be increased, and product manufacturing time may be reduced, offering an efficient solution for creating interlayer connections.

In at least one embodiment, in particular in another preferred embodiment, alternatively or additionally at least one cavity may be filled with an electrically conductive paste like "LF-371" paste from copprint or the like. This LF-371 paste is a screen printing conductive copper paste for being printed, in particular by thick screen-printing, onto FR4, glass and aluminum substrates.

Both conductive pastes exemplarily mentioned herein have advantageous properties with respect to the present invention, in particular advantageous viscosities, an advantageous curing/sintering behavior and as well advantageous electrically conductivity.

Of course, one or more other suitable electrically conductive pastes may be used, in particular a paste having substantially the same properties or similar properties as the two pastes exemplarily mentioned above.

A method for manufacturing a component carrier according to the second aspect of the present invention comprises at least the following steps:
a) providing a first component and a second component each component comprising a component main surface,
b) forming a stack having a stacking direction and comprising at least one electrically insulating layer structure and at least one electrically conductive layer structure, wherein forming said stack includes:
   embedding the first component and the second component one above the other in stacking direction and with a cavity in between and with their main surfaces facing towards said cavity and delimiting said cavity in stacking direction partially, and
   filling said cavity with an electrically conductive paste; and
c) providing a component carrier with the formed stack.

A method according to the second aspect of the present invention allows to realize thinner buildups with more than one component layer. The method allows manufacturing of a component carrier with a small height and therewith a very compact component carrier by which miniaturization can be improved, in particular of electronic packages comprising at least one component carrier. In particular, embedded packages may be further miniaturized.

Further, a method according to the present invention allows in a very easy manner to establish direct and straight electrical connections with a short path length between components, in particular between embedded components being stacked in a component carrier, wherein an electrical connection between at least two components may in particular be established via the electrically conductive paste by which the cavity in between said components is filled with during manufacturing. A method according to the invention further allows to establish reliable vertical or Z-axis interconnections, in particular direct and straight and therewith as short as possible interconnections, between components arranged one above the other in different layers.

In summary, a method according to the present invention allows further miniaturization while at the same time offering a high degree of flexibility in terms of adaptation to the various applications.

The stack preferably comprises a plurality of layer structures, in particular at least one electrically insulating layer and at least one electrically conductive layer structure.

For an easy establishment of an electrical connection, in particular for establishing a direct electrical connection, preferably in stacking direction (which might be a vertical direction) between the first component and the second component, the first component and the second component may in particular being arranged in the stack such that they are finally at least partially overlapping one to each other from a top view. They can also be arranged fully overlapping.

The first component and/or the second component may in particular comprise at least one electrically conductive structure, for example at least one pad, which is in particular facing to said cavity, wherein in a preferred embodiment, the components are relatively arranged to each other such that at least the respective electrically conductive structures (e.g., the pads) are overlapping sufficiently one to each other from a top view for establishing an electrical connection.

The main surfaces of the first component and the second component, delimiting said cavity in between may have a congruent surface shape. However, this is not mandatory, and they alternatively may have different surface shapes and sizes. Only a certain degree of overlapping for establishing the electrical connection is necessary. The less the lateral side offset is, the more straight the electrical connection might be established. The straighter said electrical connection can be established in stacking direction and therewith the more direct, the shorter the electrical path length will be and therewith the better the electrical performance of said electrical connection.

In a preferred embodiment, the first component and the second component are arranged, in particular embedded in the stack such that a direct electrical connection in stacking direction, preferably in a vertical direction, can be established between the first component and the second component by the conductive paste filled in the cavity delimited at least partially by the first component and the second component.

In at least one embodiment, the first component and the second component are being electrically connected with each other by said electrically conductive paste.

Thereby, in a very easy manner a direct electrical connection between the first component and the second component can be established within the component carrier, wherein in particular a very short and straight electrical connection can be established with the advantages described above.

In at least one embodiment, forming the stack may include at least one of the following steps, preferably all of them:
forming a first sub-stack comprising the first component and a first part of said cavity to be filled with the electrically conductive paste, wherein the first component is at least partially being embedded into said first sub-stack,
forming a second sub-stack comprising the second component and a second part of said cavity to be filled with the electrically conductive paste, wherein the second component is at least partially being embedded into said first sub-stack,
filling the first part of said cavity and/or the second part of said cavity with the electrically conductive paste, and
providing the first sub-stack and the second sub-stack one above the other in stacking direction with the first part of said cavity and the second part of said cavity facing to each other, thereby composing the cavity, which is in particular a common cavity, between the first component and the second component of the first part of the cavity of the first sub-stack and the second part of the cavity of the second sub-stack.

Thereby, in a very easy and efficient manner the stack for a component carrier according to the present invention may be formed.

Before providing the first sub-stack and the second sub-stack one above the other in stacking direction, in particular the first part of said cavity and/or the second part of said cavity is in particular being filled with the electrically conductive paste such that the (resulting common) cavity is being completely filled with the electrically conductive paste.

The first part of said cavity end of the second part of said cavity may in particular be slightly overfilled with the conductive paste to ensure complete filling of said (common) cavity. The electrically conductive paste may squeeze out, in a particular slightly, especially in the area of a parting line or separation surface between the first sub-stack at the second sub-stack.

In at least one embodiment, forming the first sub-stack and/or the second sub-stack may include at least one of the following steps, preferably all of them:
- providing a first sub-carrier and/or a second sub-carrier, in particular comprising a core layer structure,
- forming a cavity in said first and/or second sub-carrier for the arrangement of the first component and/or the second component respectively,
- embedding the first component and/or the second component at least partially in the respective sub-carrier in the respective cavity, and
- forming a part of the (common) cavity which is configured to be filled with the electrically conductive paste in each sub-stack, wherein in particular in the first sub-stack a first part of said (common) cavity is formed and/or in the second sub-stack a second part of said (common) cavity is formed.

This allows a very easy and efficient manner the forming of said stack. Additionally or alternatively, this may ensure a reliable mechanical and/or electrical connection between the respective components.

In at least one embodiment, embedding the first component and/or the second component in the respective sub-stack may include at least one of the following steps, preferably all of them:
- providing at least one temporary carrier layer structure,
- providing the respective component in the respective cavity of the respective sub-carrier on said temporary carrier layer structure,
- embedding said component by using electrically insulating material, wherein embedding in particular includes providing an insulating layer structure, in particular on said core-layer structure of the respective sub-carrier on the opposed side of said temporary carrier layer structure, and
- removing said temporary carrier layer structure.

The use of temporary carrier layer structure may increase mechanical stability during forming of the stack, wherein this may in particular result in a more precise sub-carrier and a more precise sub-stack The order of the method steps described above is in particular a preferred order, wherein the steps of providing at least one temporary carrier layer structure, providing the respective component in the respective cavity of the respective sub-carrier on said temporary carrier layer structure, embedding said component by using electrically insulating material, and removing said temporary carrier layer structure are in particular performed in this order consecutively, i.e. first the step of providing at least one temporary carrier layer structure is performed, then the step of providing the respective component in the respective cavity of the respective sub-carrier on said temporary carrier layer structure, then the embedding step and then the removing step.

In some embodiments, removing of the temporary carrier layer structure may be omitted. Then they originally "temporary" carrier layer structure will become a permanent carrier layer structure. However, removing the (temporary) carrier layer structure has the advantage that a component carrier may be provided having a smaller height compared to a component carrier having at least one permanent carrier layer structure. Contrary to this, remaining the carrier layer structure may allow to provide a component carrier having a higher mechanical strength, in particular a higher mechanical stiffness or form stability. This might in some cases also be an advantage. It may depend on the use case and/or application of the component carrier, what may be preferred.

In at least one embodiment, at least one part of said (common) cavity is formed by providing a recess in an insulating layer structure composing the stack.

Such a recess may in particular be formed or created by a mechanical process as, for example, by drilling or milling, in particular by laser drilling or mechanical drilling. In at least one embodiment, in particular in a preferred embodiment of the method according to the present invention, the first part of the (common) cavity is provided by a recess in the first external layer structure of the first sub-stack, and/or the second part of the (common) cavity is provided by a recess in the first external layer structure of the second sub-stack, wherein at least one recess is preferably made by laser drilling or mechanical drilling. As a result, at least one recess may comprise a tapered lateral wall.

In an advantageous embodiment, at least one recess may be created only after precuring of the respective layer structure in which the recess is brought in.

Thereby, the layer structure may be provided in a state having a sufficient stiffness for mechanical processing, in particular for laser drilling or mechanical drilling to create at least one recess, whilst by a subsequent lamination process still a proper and advantageous joint with the other sub-stack, in particular its corresponding layer structure, can be achieved.

In at least one embodiment, wherein, whilst the first sub-stack and the second sub-stack are arranged one above the other at least one first external layer structure is in a precured state.

This allows to achieve, in particular by a subsequent lamination process, a proper and advantageous joint between the sub-stacks, in particular its corresponding layer structures.

For an advantageous and efficient manufacturing of said component carrier at least one first external layer structure may comprise or may be made of a prepreg.

In at least one embodiment, after the first sub-stack and the second sub-stack have been provided one above the other at least curing process may be applied to said stack, in particular for curing the electrically conductive paste in the cavity and/or for curing at least one insulating layer structure, in particular for curing of at least one external layer structure, and/or any other structure of said stack to be cured (e.g., electrically conductive paste located in at least one vias) or any other structure of said stack to be cured.

In at least one embodiment, preferably at least the electrically conductive paste of one cavity and at least one layer structure of said stack are cured simultaneously. Preferably all parts of said stack to be cured are cured simultaneously, wherein for curing in particular heat and/or pressure may be applied to said stack, wherein the pressure may in particular be applied in stacking direction.

Thereby, proper lamination of the stack may be achieved and/or be ensured.

In at least one embodiment, the method further comprises a step of providing at least one alignment structure, wherein at least one alignment structure is provided on and/or in at least one sub-stack, in particular on and/or in at least one sub-sub-carrier, at least partially, for alignment of the intermediate layer and/or the alignment of the paste and/or the alignment of a sub-carrier and/or the alignment of a sub-stack and/or combinations thereof and/or an alignment of at least two of them relatively to each other, in particular when forming said stack.

At least one electrically conductive structure of the component carrier may in particular be provided in and/or on at least one sub-stack and/or in and/or on particular at least one sub-carrier.

Thereby, in an easy manner proper alignment may be achieved and as a result efficient manufacturing of the component carrier is possible.

In at least one embodiment, the method further comprises a connection step of establishing an electrically connection of at least two elements of said component carrier, in particular of at least two sub-stacks and/or at least two sub-carriers.

Thereby, a component carrier having an extended functionality may be provided.

In at least one embodiment, the step of providing a component carrier comprising a formed stack further includes providing at least one (external) electrically conductive stack layer structure on at least one external surface of said stack for establishing an electrical connection between said stack and at least one external electronic component, wherein providing of said (external) electrically conductive stack layer structure in particular includes electrically connecting of said electrically conductive stack layer structure with at least the first component and/or the second component embedded in said stack.

The electrically conductive stack layer structure may be a layer which may be made of copper or comprise copper and which may, for example made by plating.

In at least one embodiment, said external electrically conductive layer structure may first be applied onto the external surface (in particular onto the entire external surface) of said stack and in particular later be defined by a subsequent removal process using an etching process. Alternatively, the external electrically conductive layer structure may be applied only partially onto the external surface.

An electrical connection between the at least one (external) electrically conductive stack layer structure and the first component and/or the second component may be established by soldering, in particular by using solder balls being provided on an external and exposed surface facing away from said cavity of said component.

Thereby, a reliable electrical connection may be provided.

After processing interior layer structures of the component carrier, in particular after forming the stack, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In at least one embodiment, a component carrier according to the first aspect of the invention, in particular at least one stack of the component carrier, may further comprise a solder resist layer structure and/or a protective layer structure, wherein the protective layer structure may in particular be applied at least partly to at least a part of the electrically conductive layer structure.

In the context of the present application, the term "solder resist layer structure" may particularly denote a layer structure which may also be named as "solder mask" and which may in particular be applied to a surface of another layer structure, in particular to a main surface of said other layer structure, to prevent solder from adhering to unintended areas of said surface of said other layer structure during the soldering process. Thus, ensuring that solder is applied only to designated areas, as for example to designated solder pads, but not on the spaces in between these designated areas.

In at least one embodiment, the solder resist layer structure may be an electrically insulating solder resist layer structure. In at least one embodiment, the solder resist layer structure may be applied to a main surface of an electrically conductive layer structure and/or to a main surface of an electrically insulating layer structure, wherein the solder resist layer structure may in particular be applied to the outmost main surface of the at least one electrically conductive layer structure of a component carrier. The solder resist layers structure may be applied to one or both opposing main surfaces of a layer structure or a stack, wherein the solder resist layer structure may in particular be applied to the outmost main surfaces of the layer structure or the stack. The solder resist layer structure may be applied in terms of or by surface treatment.

In at least on embodiment, the solder resist layer structure may be formed by applying the solder resist layer structure onto an entire main surface of a layer structure to be covered first, and then subsequently pattern the solder resist layer structure so as to expose one or more surface portions of the layer structure coated by the solder resist layer structure before. The solder resist layer structure may in particular be applied onto an entire main surface of an outmost electrically conductive layer structure of a component carrier first, and then subsequently be patterned so as to expose one or more electrically conductive surface portions of the electrically conductive layer structure coated by the solder resist layer structure before. Thereby, at least one opening in the solder resist layer structure may be formed, wherein at least one opening may be delimited by at least one lateral wall of said solder resist layer structure, wherein at least one lateral wall particularly limits the opening in a lateral or transversal direction to the stacking direction.

At least one exposed portion of the electrically conductive layer structure of the component carrier may in particular be configured or may be used for electrically coupling of the component carrier to an electronic periphery. The remaining and by the solder resist layer structure covered surface portions - that means the unexposed surface portions - may be efficiently protected against oxidation or corrosion, in particular surface portions containing copper. Thereby, a component carrier may be provided which is configured for being electrically coupled to an electronic periphery by using one or more of the exposed surface portions of the main surface of an electrically conductive layer structure, wherein the remaining portions of said electrically conductive layer structure remains covered by the solder resist layer structure and therewith efficiently protected against oxidation or corrosion, which applies in particular for surface portions containing copper. At least one solder resist layer structure may comprise at least one of the following group comprising epoxy resin, phenol resin, polyimide resin, polyester resin, bismaleiminde resin, polyolefin-based resin, isocyanate-based resin, poly(meth)acrylate resin, and polyethylene terephthalate resin and/or a combination thereof.

In the context of the present application, the term "protective layer structure" may in particular denote a layer structure which can be considered as a "surface finish layer structure" and which is in particular configured to prevent a surface, to which the protective layer structure has been applied to, from changing one or more of its characteristic properties within a defined timeframe under defined conditions.

A protective layer structure may in particular be, for example, a layer structure which may be applied to at least one exposed portion of an electrically conductive layer structure for the time being until an electric connection is established between the exposed portion and, for example, an electronic periphery. If an exposed surface portion of an electrically conductive layer structure is left unprotected, then the exposed electrically conductive layer structure material (in particular copper) might oxidize. This may result in a change of one or more characteristic properties of the electrically conductive layer structure in the zone of the exposed surface portion and making a component carrier with such an electrically conductive layer structure less reliable.

The protective layer structure has the function to protect the exposed electrically conductive layer structure (in particular copper circuitry) and enable a joining process, in particular reliable electrical connection process, with one or more components, for instance by soldering.

In at least one embodiment, at least one protective layer structure may be applied selectively to one or more exposed electrically conductive surface portions of an electrically conductive layer structure of the component carrier in terms of or by surface treatment.

A protective layer structure may comprise or be an electrically conductive cover material configured to be applied on exposed electrically conductive layer structures (such as pads, conductive tracks, etc., in particular comprising or consisting of copper) of a surface, in particular of an outmost and electrically conductive main surface of a component carrier. Examples for appropriate materials for protective layer structure material are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

A protective layer structure may be formed for instance as an interface or to act as an interface between a surface mounted component and the component carrier.

A package according to the third aspect of the present invention, comprises at least one component carrier according to the first aspect of the present invention and/or at least one component carrier manufactured by a method according to the second aspect of the invention and at least one further part, being assembled with the component carrier.

In the context of the present application, the term "package" may particularly denote a setup or unit that integrates a component carrier and at least one further part.

In the context of the present application, the term "further part" may particularly denote any part which is being configured for forming a package together with at least one component carrier. This may include other hardware, software, or mechanical parts to form a functional package or assembly or device or a module of a larger system.

In at least one embodiment, the package is an electronic package or assembly. The package may comprise at least one electronic component.

A package may be, for example, an electronic circuit board comprising at least one component carrier according to the present invention and at least one further part, wherein one or more further parts may be formed by parts and/or components being electrically connected (to each other and/or with the component carrier).

A package may be, for example, an electronic module, an electronic device or any sub-assembly for an electronic device, comprising at least one component carrier according to the present invention and at least one further part.

Examples for electronic devices are smartphones, computers and laptops, televisions and monitors, wearable devices (like ,e.g., smartwatches and/or fitness trackers), home devices (such as, e.g., microwave ovens, refrigerators, and washing machines), medical devices (like, e.g., blood glucose meters and portable ultrasound machines), electronic devices for the automotive industry (like, e.g., ECUs for engine management, infotainment systems, safety systems (like, e.g., airbags), and navigation systems), electronic devices for industrial machinery (like, e.g., control units for automation, robotics, and manufacturing equipment).

Examples for sub-assemblies for electronic devices are in particular electronic modules for the electronic devices mentioned above. Examples for modules are in particular electronic control units (ECUs), power supply modules, connectivity or communication modules (like, e.g., HDMI or USB ports, WiFi modules, Bluetooth modules and GSP modules), sensor modules (e.g., heart rate, GPS), microcontroller modules, battery management modules, display interface modules, driver modules, audio modules, RFID modules, and memory modules.

The preferred embodiments presented with reference to a component carrier and its advantages apply correspondingly to a method for manufacturing a component carrier according to the invention, and to the package as well and vice versa.

Further features of the invention are shown in the claims, the figures and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### SHORT DESCRIPTION OF THE DRAWINGS

The aspects of the present invention defined above, and further aspects of the invention are apparent from the examples will now be explained in more detail by means of a preferred embodiment example and with reference to the accompanying, but not limiting drawings.

The drawings show:
- **Fig. 1a:**: a cross-section through a first embodiment of a component carrier according to the first aspect of the present invention, which has been manufactured by a method according to the second aspect of the present invention,
- **Fig. 1b:**: an enlarged sectional view of the embodiment shown in Fig. 1a,
- **Fig. 2:**: a cross-section through a second embodiment of a component carrier according to the first aspect of the present invention, which has also been manufactured by a method according to the second aspect of the present invention,
- **Fig. 3:**: a flow-chart showing steps of a method according to the second aspect of the present invention for manufacturing a component carrier according to the first aspect of the present invention,
- **Fig. 4a:**: process steps S1 to S9 of a first embodiment of a method according to the second aspect of the present invention for forming a stack of another embodiment of a component carrier according to the first aspect of the present invention,
- **Fig. 4b:**: subsequent process steps S10 to S16 for further forming of a stack of another embodiment of a component carrier according to the present invention,
- **Fig. 5:**: a sectional view of a cross-section of another exemplary embodiment of a component carrier according to the present invention,
- **Fig. 6:**: a sectional view of a cross-section of a further exemplary embodiment of a component carrier according to the present invention,
- **Fig. 7:**: a sectional view of a cross-section of a further exemplary embodiment of a component carrier according to the present invention,
- **Fig. 8:**: a sectional view of a cross-section of a further exemplary embodiment of a component carrier according to the present invention,
- **Fig. 9:**: a sectional view of a cross-section of a further exemplary embodiment of a component carrier according to the present invention, and
- **Fig. 10:**: a sectional view of a cross-section of a further exemplary embodiment of a component carrier according to the present invention, and
- **Fig. 11:**: a cross-section through a further embodiment of a component carrier according to the first aspect of the present invention.

### DETAILED DESCRIPTION

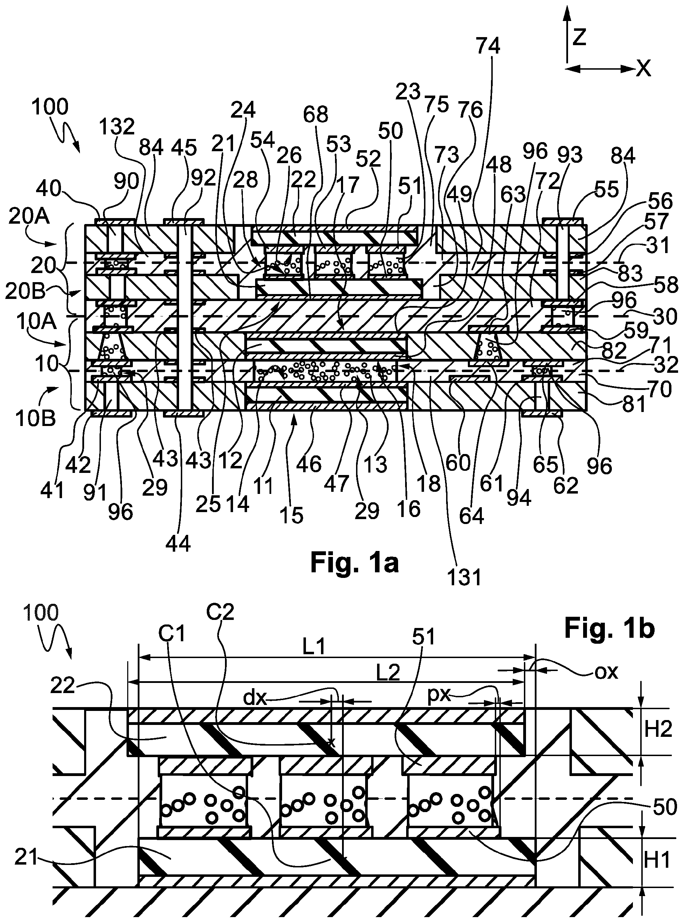

**Fig. 1a** illustrates a cross-section through a first embodiment of a component carrier 100 according to the first aspect of the present invention, which has been manufactured by a method according to the second aspect of the present invention. In the following, the component carrier 100 will be described in detail before below the method of manufacturing used for manufacturing of said component carrier 100 will be explained. Elements of different embodiments having the same function may be named with the same reference signs.

This example of a component carrier 100 according to the present invention is a multilayer component carrier 100 comprising a first stack 10 and a second stack 20, wherein each stack 10, 20 has a stacking direction Z and comprises several electrically insulating layer structures and several electrically conductive layer structures.

The first stack 10 comprises first electrically insulating layer structures 70 and 71 being laminated together to one common intermediate electrically insulating layer structure 131, and several electrically conductive layer structures, inter-alia the electrically conductive layer structures 40, 41, 42, 43, 44, 60-65 and 59.

The second stack 20 comprises first electrically insulating layer structures 73 and 74, also being laminated together and forming a common intermediate electrically insulating layer structure 132, and also several electrically conductive layer structures, inter alia the electrically conductive layer structures 40, 45, 55, 56, 57, 58 and 68. Both stacks 10 and 20 of this exemplary component carrier 100 comprise further structures not indicated with a reference sign.

According to the present invention, each stack 10, 20 comprises a first component 11, 21 and a second component 12, 22 embedded in the corresponding stack 10, 20, wherein the components 11 and 12 respectively 21 and 22 of said stacks 10, 20 are arranged one above the other with a single cavity 13 respectively with three cavities 23 in between in stacking direction Z, wherein in Fig. 1a only one of the three cavities 23 is indicated with reference sign 23. Cavities 23 are separated from each other by electrically insulating layer material from electrically insulating layer structures 73, 74.

The first component 11, 21 and the second component 12, 22 of a stack 10, 20 of a component carrier 100 according to the present invention may be of the same component type or of different types of components. Different types of components may in particular serve different (electrical/electronical) purposes. Thereby, number of use cases of a component carrier 100 may be increased significantly in a very easy manner. In combination with a design of the component carrier according to the present invention, this may allow to provide a component carrier which can be adapted very easy and flexible for a high number of use cases in a very easy manner.

Each of the components 11, 12, 21 and 22 of the embodiment illustrated in Fig. 1a of a component carrier 100 according to the present invention comprises electrically conductive connection structures 46, 47, 48, 49, 50, 51, 52, 53 and 54 exemplarily illustrated in Fig. 1 for establishing an electrical connection with the component 11, 12, 21, 22.

The components 11 and 12 of the first stack 10 each comprise a main surface 14 respectively 16 facing towards said cavity 13 in between and delimiting said cavity 13 in stacking direction Z partially.

The component 21 and 22 of the second stack 20 also each comprise a main surface 24 respectively 26, wherein main surface 24 is associated to component 21 and main surface 26 is also associated to component 22. Said main surfaces 24 and 26 are also facing towards the cavities 23 in between the components 21 and 22.

Each component further comprises a second main surface on the opposed side facing away from said cavity 13, 23, what is exemplary illustrated for components 11, 12 and 21 by component main surfaces 15, 17 and 25. Said second main surfaces 15, 17 and 25 are located opposite the first main surfaces 14, 16, 24, 26 and comprise further connection structures, as for example pads (see for example structure 46 for component 11 with respect to the second main surface 15 of component 11), enabling double sided connection of the respective components 11, 12, 21, 22.

According to the present invention, the cavities 13 and 23 between the respective first and second components 11, 12 and 21, 22 of the first stack 10 and the second stack 20 are each filled with an electrically conductive paste 29, thereby being directly electrically connected with each other.

The direct arrangement of the components 11, 12 respectively 21, 22 one above the other with a cavity 13 respectively 23 in between being filled with an electrically conductive paste 29 and thereby being directly electrically connected to each other allows providing a component carrier 100 with a very small height. Thereby miniaturization can be improved, in particular of electronic packages comprising such a component carrier 100. This allows further to provide a component carrier 100 with direct and straight electrical connections between the components 11 and 12 respectively 21 and 22 with a short path length between said components 11 and 12 respectively 21 and 22. Thereby improved performance of the component carrier 100 may be achieved.

In this embodiment of an advantageous component carrier 100 according to the present invention, the cavities 13 and 23 of both stacks 10 and 20 are in lateral direction, which is indicated by X in Fig. 1a and which in this embodiment is in particular extending in a direction perpendicular to stacking direction Z, partially delimited by an electrically insulating layer structure. Cavity 13 is delimited in lateral direction by the electrically insulating layer structures 70 and 71 respectively the intermediate insulating layer structure 131, and the cavities 23 out delimited in lateral direction by the electrically insulating layer structures 73 and 74 respectively the intermediate layer structure 132.

As exemplary illustrated for cavity 13, this cavity 13 is in particular delimited in its entirety by the first component 11 the second component 12 and the first electrically insulating layer structures 70 and 71 only.

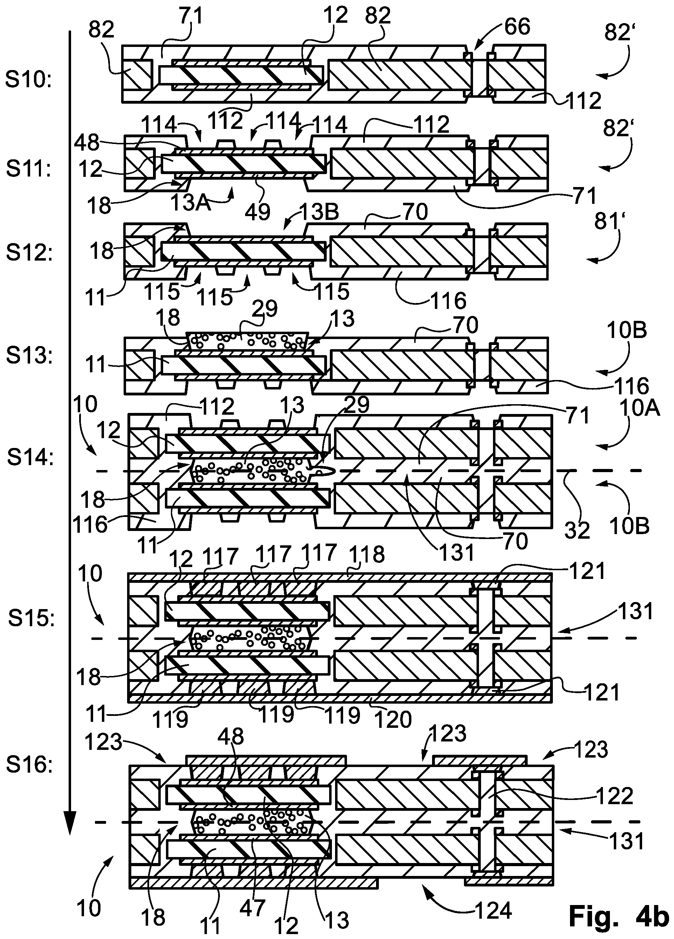

A lateral wall 18, 28 of said cavities 13 and 23 may extend in a direction parallel to stacking direction Z and or may be inclined to stacking direction Z, wherein said lateral wall 18, 28 may in particular be tapered (see e.g., Fig. 4b, S11 to S13). Shape, orientation and extension of the lateral walls 18, 28 of cavities 13, 23 being filled with the electrically conductive paste 29 may in particular depend on the process by which the cavity 13, 23 has been created. In particular, when creating the cavity 13, 23 by laser drilling, the lateral wall 18, 28 of the cavity 13, 23 may be tapered as for example illustrated in Fig. 4b, S11 to S13.

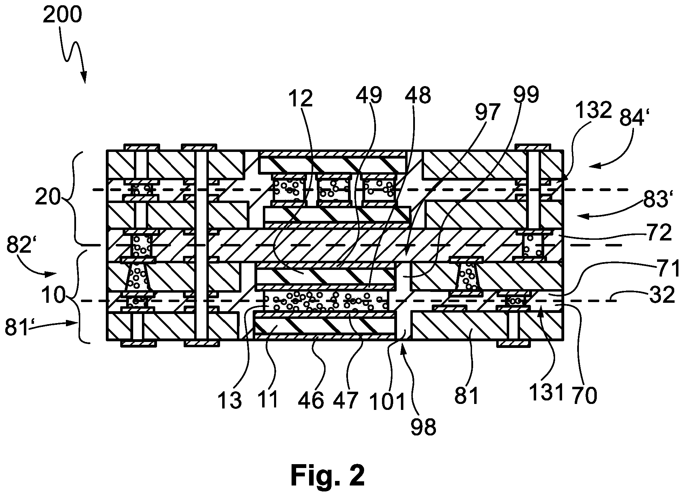

Each component of this exemplary embodiment of a component carrier 100 according to the present invention is embedded into a sub-carrier 81', 82', 83', 84' (see Fig. 2), in particular in a respective core structure layer 81, 82, 83, 84 of the respective sub-carrier 81', 82', 83', 84'. Component 11 is for example embedded into core structure layer 81 and component 12 is for example embedded into core structure layer 82. Component 21 is embedded in core structure layer 83 and component 22 is embedded in core structure layer 84. The core structure layers 81, 82, 83, 84 are preferably also electrically insulating layer structures, but comprising functional features like glass fibres or one or more inorganic layer structures inside for increased mechanical strength and/or stiffness of said layer structure.

In at least one other embodiment, at least one sub-carrier may optionally be free of a core structure layer, i.e., the sub-carrier does not comprise any core structure layer. At least one component may be embedded into another part, in particular into another layer, of said core structure free sub-carrier. For example, at least one component may be embedded into an(other) electrically insulating layer structure.

The components 11, 12, 21 and 22 are each embedded such into the respective sub-carriers 81', 82', 83', 84' respectively their core structure layers 81, 82, 83, 84 that their main surfaces 14, 16, 24, 26 are exposed and facing towards the respective cavity 13, 23 and delimiting said cavity 13, 23 partially, wherein the components 11, 12, 21, 22 are further embedded such that they are facing towards the other component 12, 11, 22, 21 and the corresponding sub-carrier 81', 82', 83', 84', into which the other component, which also delimits said cavity 13, 23 partially, is embedded.

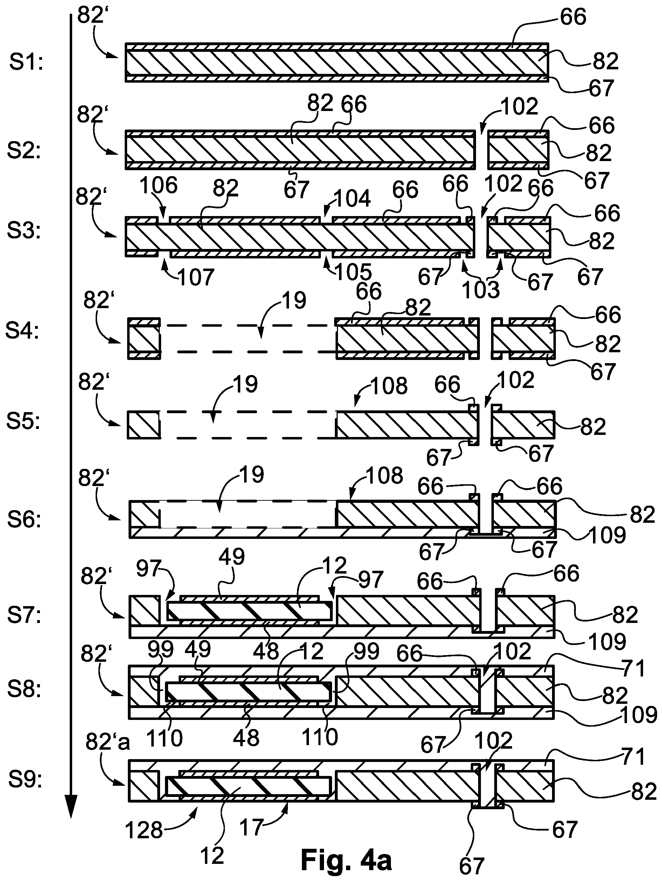

For embedding the components 11, 12, 21, 22 into the core structure layers 81, 82, 83, 84, in the manufacturing process of said component carrier 100 first component cavities 19 (see Fig. 4a) had been created, in particular by a cutting process, for example by laser cutting, in which later on the components 11, 12, 21, 22 have been positioned and embedded.

Said component cavities 19 (see e.g., Fig. 4a, S4 to S6) may have a lateral extension in lateral direction X exactly fitting to the dimension of the component as it is exemplary illustrated, for example, for components 11 and 12 in Fig. 1a, or they may have a lateral extension being larger than the lateral dimension of the respective component, as it is the case for components 21 and 22 of the component carrier 100 illustrated in Fig. 1a. In this case the portions 75, 76 of the electrically insulating layer structures 73, 74 delimiting the cavities 23 being filled with electrically conductive paste 29 may extend into a space 97 between the component 21, 22 and the lateral wall of the corresponding core structure layer 83, 84 delimiting the component cavity 19 (see also Fig. 4a., S7 and S8).

The cavities 13 and 23 are each at least partially formed by a recess in the electrically insulating layer structures 70, 71, 73 and 74 delimiting said cavities 13, 23 in lateral direction X, wherein the cavities 13 and 23 are in particular delimited in lateral direction X by the lateral walls of said recesses in the electrically insulating layer structures 70, 71, 73 and 74.

In this embodiment of a component carrier 100 according to the present invention illustrated in Fig. 1a, the component's main surfaces 14, 16, 24, 26 facing towards the cavities 13 respectively 23 are each in flush respectively on the same vertical level in stacking direction Z with the respective main surfaces 108 (see Fig. 4a) of the core structure layers 81, 82, 83, 84. However, in another embodiment this may be different. In another embodiment, for example, at least one component may for example have a component height in stacking direction Z being less than the inner height of the component cavity 19 (see Fig. 4a) the component is embedded into. Alternatively and in general, the component height may be larger than the inner height of the respective component cavity 19 resulting in a component protruding out of the corresponding core structure layer the component is embedded into in stacking direction Z.

Each of said stacks 10 and 20 itself comprises a first sub-stack 10A respectively 20A and a second sub-stack 10B respectively 20B, wherein these sub-stacks 10A, 10B, 20A, 20B have been stacked one above the other to form the respective stacks 10 and 20.

Each sub-stack 10A, 10B, 20A, 20B comprises a sub-carrier 81', 82', 83', 84' with a core structure layer 81, 82, 83, 84, in which a component 11, 12, 21, 22 is embedded, wherein between the sub-stacks 10A and 10B and between the sub-stacks 20A and 20B an electrically insulating layer structure 131 respectively 132 is provided, each being made of two separate external insulating layer structures 70 and 71 respectively 73 and 74 of the corresponding sub-stacks 10A and 10B respectively 20A and 20B when forming the stacks 10 and 20. This allows a very easy and efficient and precise manufacturing of a component carrier comprising at least two components arranged one above the other in stacking direction.

In an alternative embodiment, the electrically insulating layer structures 131 and 132 may consist or be made of one electrically insulating layer structure only. This may help to reduce stacking height and to enhance miniaturization.

The component carrier 100 illustrated in Fig. 1a is manufactured by stacking the first stack 10 and the second stack 20 one above the other with the electrically insulating layer structure 72 in between. This is indicated in Fig. 1a by separation plane 30 symbolically illustrated as a dotted line. Alternatively to the embodiment exemplary illustrated in Fig. 1a, in which the electrically insulating layer structure 72 is generated from two single electrically insulating layer structures combined to a common insulating layer structure 72, the insulating layer structure 72 in between the first stack 10 and the second stack 20 may also be an insulating layer structure being associated to only one of said stacks 10 and 20. In another embodiment, between the first stack 10 and the second stack to also two separate electrically insulating layer structures may be provided.

Dotted line indicated with reference sign 31 indicates the separation plane between the electrically insulating layer structures 73 and 74 before being laminated together to a common electrically insulating layer structure 132. In some embodiments, they may be laminated together such that no separation plane may be visible any longer.

Dotted line indicated with reference sign 32 indicates the separation plane between the electrically insulating layer structures 70 and 71 before being laminated together to a common electrically insulating layer structure 131. In some embodiments, they may be laminated together such that no separation plane may be visible any longer.

First stack 10 and second stack 20 are stacked above each other in stacking direction Z with an electrically insulating layer structure 72 in between, wherein the first stack 10 and the second stack 20 are electrically connected with each other via several electrically conductive structures as it is in general well known from prior art, for example via electrically conductive structures 40 and 90, 96, 41, 91 and 42, and 45, 92, 43 and 44, and 58, 59 and 126.

Therein, the electronically conductive structures 40, 41, 42, 43, 44, 45, 58, 59 are formed as pads. They are plated onto the respective adjacent arranged surfaces and comprise a certain amount of copper or are made of copper to ensure good electrical conductivity. Alternatively, the electrically conductive structures may comprise Ni, Pd, Cr, Ti, Ag, Au or Sn.

Electrically conductive structures 90, 91 and 92 are in this example so-called through-hole connections, comprising a through-hole being filled with an electronically conductive material, as for example copper, or having an inner surface onto which an electrically conductive coating is applied, in particular plated, which may for example also be comprise copper or consist thereof.

The electrical connection being established between electrically conductive structures 58 and 59 comprises, as exemplarily illustrated in this embodiment, an electronically conductive structure being formed by an electrically conductive paste 29 which is filled into a further cavity 96, and by which further electrical connections in this exemplary embodiment of a component carrier 100 are also based on, for example several electrical interconnections within said stacks 10, 20.

The paste 29, by which the further cavities 96 are filled with, is in the illustrated embodiments herein the same as that one in the cavities 13 and 23, by which the components 11, 12, 21, 22 are connected. In other embodiments, the pastes used may be different. In particular, the paste used for filling the cavities 13, 23 between the components 11, 12, 21, 22 might be different from that one the further cavities 96 are filled with. It might be advantageous, if the cavities 13, 23 between the components 11, 12, 21, 22, preferably only these cavities 13, 23, are filled with a paste which has a better electrical and/or thermal conductivity than the paste for filling further cavities 96. Thereby, an advantageous electrical and/or thermal connection between the respective components 11, 12, 21, 22 may be achieved, but the amount of the usually more expensive higher conductive paste needed for the component carrier may be reduced or even minimized.

Further electrically conductive structures, like for example through-hole connections 90, 91, 93 or 94, may be provided.

In some embodiments, not all further cavities 96 might be filled with paste for establishing a layer to layer connection. One or more of them may at least partially or completely be filled with a plating material, for example with Cu, Ni, Pd, Cr, Ti, Ag, Au or Sn. However, in a preferred embodiment, within one insulating layer structure, only one type of conductive filling medium is chosen, i.e., in particular a plating material or a conductive paste. But this does not count for (mechanically) drilled holes reaching through several insulating layers.

In an example, the electrically conductive structure formed by the paste 29, which is filled into a further cavity 96, may comprise a shape having straight side walls, for example a cylindrical shape and/or a shape having inclined side walls, for example a frustoconical shape. This may in particular depend on the manufacturing method which is used to create the cavity.

**Fig. 1b** shows an enlarged sectional view of the embodiment shown in Fig. 1a, wherein from this enlarged view of Fig. 1a it becomes apparent that the first component 21 and the second component 22 are stacked one above the other with a defined, slight lateral shift dx in lateral direction X relative to each other between their geometrical center points C1 and C2 in lateral direction. Depending on the size of the components 21 and 22, in particular depending on their extension/length L1, L2 in lateral direction, this may result in a zone with an extension ox in lateral direction, where no overlapping of said components 21 and 22 occurs. Are the components 21 and 22 of the same size, in particular of the same length, i.e., with L1 = L2, the width ox of the non-overlapping in lateral direction is the same as the lateral shift dx, i.e. dx = ox.

It is immediately apparent from the illustrations in Fig. 1a and 1b that for reliable electrical and/or thermal connection of the components 21 and 22 stacked one above the other, a minimum overlapping of the components 21 and 22 is necessary.

However, the overlapping of the components 21 and 22 is less crucial than sufficient overlapping of their conductive connection structures to be connected, for example of their pads 51 and 50 illustrated. For the establishment of reliable connections, the overlapping of the conductive connection structures 50, 51 of the components (e.g., of the respective pads 50, 51, in particular of their pad area) should at least be 50%. In some embodiments, a higher overlapping may be required. In some embodiments, an admissible deviation or admissible lateral shift of the pads 50, 51 to be connected relative to each other (in Fig. 1b illustrated as "px") from ideal overlapping may be limited, in particular to small deviations, for example to maximum 10 µm. Instead of being indicated with an absolute value, the limit may also be defined in percent, in particular based on a pad size, for example on the pad size of the smallest pad of the pads to be connected.

The components 21 and 22 of component carrier 100 shown in Fig. 1a and 1b have the same length (i.e., L1 = L2) in lateral direction X and also the same height H1, H2 in stacking direction Z, i.e., H1 = H2. This is, because in this embodiment 100, said components 21 and 22 are identical. However, in another embodiment, they may have different lengths L1, L2 in lateral direction X and/or different heights H1, H2 in stacking direction and/or be of different types, enabling different functionality. **Fig. 2** shows a cross-section through a second embodiment of a component carrier 200 according to the first aspect of the present invention, which has also been manufactured by a method according to the second aspect of the present invention. In this embodiment 200, the components 11 and 12 are also embedded in component cavities 19 into the respective sub-carriers 82' and 81', which have a larger extension in lateral direction than the components 11 and 12, wherein the lateral spaces 97 and 98 between the components 11 and 12 and the core structure layers are filled by portions 99 and 101 of the insulating layer structures 70 and 71, similar as for the components 21 and 22.

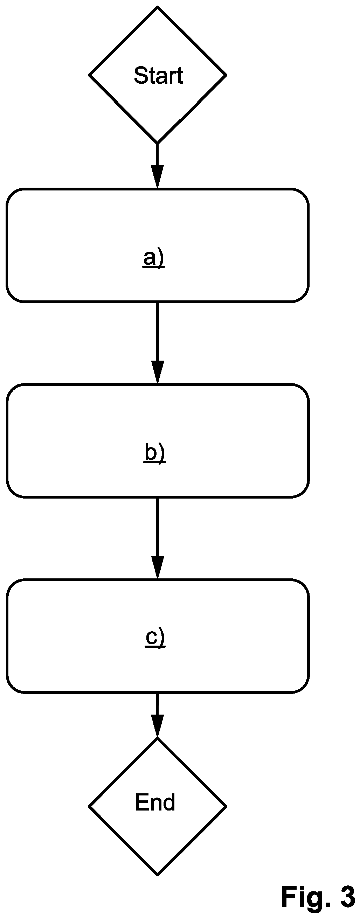

**Fig. 3** shows a flow-chart with steps of a method according to the second aspect of the present invention for manufacturing a component carrier according to the first aspect of the present invention, wherein the method described exemplarily comprises a first step a) of providing the first component 11, 21 and the second component 21, 22, wherein each component 11, 12, 21, 22 comprises a component main surface 14, 16, 24, 26. The method further comprises a second step b) of forming a stack 10, 20 having a stacking direction Z and comprising at least one electrically insulating layer structure 70, 71, 73, 74 and at least one electrically conductive layer structure, wherein forming said stack 10, 20 includes embedding the first component 11, 21 and the second component 12, 22 one above the other in stacking direction Z and with a cavity 13, 23 in between and with their main surfaces 14, 16, 24, 26 facing towards said cavity 13, 23 and delimiting said cavity 13, 23 in stacking direction Z partially and filling said cavity 13, 23 with an electrically conductive paste 29. In a third step c) a component carrier 100 may be provided with the formed stacks 10, 20.

In particular the step b) of forming the stack 10, 20 may include several sub-steps. With reference to Figs. 4a and 4b, a preferred method according to the second aspect of the present invention comprising several sub-steps therefore is described.

In **Fig. 4a** preferred process steps S1 to S9 of a first embodiment of a method according to the second aspect of the present invention for forming a stack of a further embodiment of a component carrier according to the first aspect of the present invention are illustrated. In **Fig. 4b** subsequent preferred process steps S10 to S16 for further forming of said stack are shown.

Some of the sub-steps described herein, may be omitted or may be performed in a different way in at least one embodiment of a method according to the present invention. Also, further sub-steps are possible. Some sub-steps may also be performed with a different order.

In a first step S1, a sub-carrier 82'may be provided comprising a core structure layer 82, an electrically conductive layer structure 66 made of copper plated onto a main surface 108 (here the upper surface of the core structure layer 82) of the core structure layer 82, and further comprising another electrically conductive layer structure 67, also made of copper, and plated onto the other main surface (here the bottom surface of the core structure layer 82). As already mentioned above, a sub-carrier does not mandatorily comprise a core structure layer. Thus, in an alternative embodiment the sub-carrier 82' may be free of a core layer structure, for example comprising a resin layer. Further alternatively, the sub-carrier 82' may comprise a glass core.

In a subsequent step S2, a vertical through-hole 102 through the sub-carrier 82' may be created, in particular by a mechanical manufacturing process as for example by a mechanical drilling process, preferably by a mechanical or a laser drilling process. However, also other manufacturing methods may be applicable.

In a further step S3, for example by using a photo conformable mask as it is well known from prior art, a defined removal at defined locations of the electrically conductive copper layer structure 66 and 67 may be performed for defining, in particular for marking or indexing, the position of a wanted component cavity 19, which has to be cut into the core structure layer 82 first before a component can be embedded into said sub-carrier 82'. Instead of using a photo conformable mask, other methods may be applied. After defined removal of the electrically conductive layer structures 66, 67 at defined locations said layer structures 66 and 67 may comprise several recesses or interruptions 103, 104, 105, 106, 107 indicating where the component cavity 19 has to be created, and therewith serving as registrations marks and/or positioning elements.

Said component cavity 19 may be created in a subsequent step S4, for example by laser cutting, for example by using a CO2 laser. In the example illustrated herein, the component cavity 19 is formed as a "through-hole". Alternatively, the component cavity 19 may have a basin shape.

After the component cavity 19 has been created, the electrically conductive structures 66 and 67 may be removed almost completely or completely from the main surfaces of the core structure layer 82 in a further step S5. However, in a preferred embodiment the electrically conductive structures 66 and 67 are not removed completely. Preferably, at least one alignment structure 66, 67 is kept. In this embodiment small parts of the electrically conductive layer structures 66 and 67 around the through-hole 102 remain. These alignment structures 66, 67 allow precise alignment of the sub-carrier 82' in the following process steps. They may for example be detected, in particular contactless, by radiation and/or capacitively and may indicate, how the sub-carrier 82' has to be positioned in the machine of the next process step for precise performing of the next manufacturing step.

In a subsequent step S6, in particular when the component cavity 19 is a "through-hole" component cavity 19 and/or when the mechanical strength and/or form stability of the core structure layer 82 would not be sufficient for the following process steps, a temporary carrier layer 109 may be applied onto one of the main surfaces of the core structure layer 82, wherein here the temporary carrier layer 109 is applied to the bottom main surface of said core structure layer 82. Therein, some of the alignment structures, here the alignment structures 67, may temporarily be embedded. In cases, in which the component cavity 19 has for example a basin shape, this step S6 may be omitted.

In subsequent step S7, the component (here the component 12) may be embedded into the component cavity 19, which has been created previously. Depending on the lateral extension of said component cavity 19 between the component 12 and the core structure layer 82, there will be a space 97 in lateral direction or not.

For establishing an electrical connection between the component 12 and another element, the component 12 may in particular comprise electrically conductive structures 48 and 49 on its main surfaces.

After the component 12, which has to be embedded, has been placed within said component cavity 19, in a further step S8, a first external insulating layer structure 71 may be applied onto the main surface of the core structure layer 82, here onto the upper main surface 108, wherein in this example a portion 99 of said first electrically insulating layer structure 71 is extending into said space 97 between the component 12 and a lateral wall of the core structure layer 82, and thereby filling said space 97. Due to the design of the component 12 in this example, the material of the electrically insulating layer structure 71 will also penetrate around the bottom corners of the component 12 and form a horizontal portion 110.

In another (not shown) embodiment, alternatively a glue like electrically insulating material may be applied into the space 97, for example, by 3D printing and/or dispensing, wherein the top surface of the component is preferably not being covered. That means in other words, that for embedding the component in at least one embodiment at least two different materials, in particular at least two different electrically insulating materials may be used, in particular one for forming the electrically insulating layer structure (here named with 71) and a different one for filling the gap 97.

The material of the electrically insulating layer structure 71 may also extend into through hole 102 and filled by portion 122, as it is illustrated exemplarily in Figs. 4a and 4b. In other embodiments, said through hole 102 may be left open first and later may be coated, in particular plated, or filled with an electrically conductive layer structure as it is well-known from prior art for forming through-hole connections. It may also be coated or plated with an electrically conductive layer structure, for example made of copper or comprising copper, and later on be filled with a resin to save copper material, but still allow to enable the establishment of a through-hole connection. Alternatively to copper, (Cu), Ni, Sn, Au or Ag and/or a combination thereof may be used for providing the respective electrically conductive structure.

In a further step S9, the temporary carrier layer 109 may be removed. Thereby, the bottom main surface 17 of the component 12 respectively the bottom main surface 128 of the core structure layer 82 may be exposed (again).

For some embodiments it may be advantageous, if in a further step S10 a second electrically insulating layer structure 112 is applied onto the other main surface 128 of the core structure layer 82 (here onto the bottom main surface of the core structure layer 82). If such a second electrically insulating layer structure 112 is applied onto the opposed side of the core structure layer 82 on its external main surface 128, said second electrically insulating layer structure 112 is preferably applied such that it is also in contact with one main surface of the component 12 (here main surface 17), and with the other external insulating layer structure (here layer structure 71). Portion 99 of the first electrically insulating layer structure 71 may preferably extend into said space 97 between component 12 and the lateral wall of the core structure layer 82 such that said portion 99 flushes with one main surface of the component 12 and with one main surface of the core structure layer 82. In addition, said portion 99 may further be in contact with the other external insulating layer structure 112.

The second electrically insulating layer structure 112 may also comprise a portion extending into the space 97 as portion 99 of the first external electrically insulating layer structure 71 does. Thereby, in a very easy manner complete embedding of the component 12 may be achieved.

The electrically insulating layer structures 71 and 112 are preferably only precured so far and/or in a so-called "B-stage". In this state the material, in particular the resin composing the respective electrically insulating layer structure 71 and/or 112 is neither fully uncured nor fully cured, but partially cured. In this state, the resin is in particular no longer liquid but also not yet fully solid. However, it is preferably to a certain degree tacky and semisolid and allows to be adhered to the core structure layer 82, and to be mechanically processed, in particular for the creation of one or more cavities 13A, 114 in the layer structures 17 and 112 in preparation for the following process steps.

Advantageous results can be achieved by using so-called "softlam" electrically insulating layer structures 71 and/or 112, which are configured for being processed under elevated temperature and pressure, preferably in the range from 50°C to 240°C and from 5 to 30 bar. In particular good embedding and lamination results may be achieved. Providing at least one of the insulating layer structures 71 and/or 112 in a precured state may further help to prevent an unwanted warpage during the subsequent process steps.

In a subsequent step S11, at least the first part 13A of the cavity 13, which has to be filled with the electrically conductive paste 29, is created, in particular cut, for example by laser drilling, into the preferably only precured first electrically insulating layer structure 71, wherein a main surface of the component 12 is exposed, in particular its electrically conductive structure 49. In some embodiments, in addition or alternatively a laser skiving process may be performed to remove the respective material to form the cavity 13 (at least a part 13A, 13B thereof).

"Laser skiving" is a well-known method for material removal using a laser, wherein this method allows very precise material removal with minimal substrate damage.

It has to be noted that in the illustration with respect to step S11, the sub-carrier 82' is illustrated in a state turned around by 180° (flipped upside down by 180° in alignment with Figs. 1a and 2, in which component 12 is the upper one) compared to the illustrations before.

In some embodiments, it may be advantageous to create also cavities 114 in the second electrically insulating layer structure 112, to expose also the opposed main surface of the component 12, in particular its electronically conductive structure 48, for enabling the establishment of electrical connections of the component 12 with at least one other electrical component also from and/or to this side of the component 12.

Contrary to the illustrations in Figs. 1a and 2, in this example, the lateral walls of cavity part 13A are inclined, what is well recognizable. Also, the recesses 114 have tapered lateral sidewalls (not indicated by reference sign).

After step S11, the sub-carrier 82' may be ready to be assembled with another sub-carrier 81', in particular with a similar or an identical sub-carrier 81' to a stack 10 for a component carrier according to the present invention.

Preferably, at this moment or in a further step S12 the other sub-carrier 81' for forming the stack 10 is provided with component 11 embedded therein. Said other sub-carrier 81' may in particular be manufactured according to the same method as described herein for sub carrier 82'.

Sub-carrier 81' may in particular also comprise a core structure layer 81, into which a component 11 is embedded, wherein on one of the main surfaces of the core structure layer 81 (on the side facing towards the cavity 13 being filled with electrically conductive paste 29 later) a first electrically insulating layer structure 70 has been applied, into which the second part 13B for forming the cavity 13 being filled with the electrically conductive paste 29 is cut, preferably also by laser drilling, also resulting in tapered lateral walls 18 delimiting the cavity 13 in lateral direction.

On the opposed side, i.e. facing away from cavity part 13B, a second electrically insulating layer structure 116 is applied, into which also recesses or cavities 115 have been cut to expose the respective electrically conductive structure on the side of the component 11 (not indicated).

In a preferred embodiment in a further step S13, at least one of the cavity parts 13A, 13B is filled with the conductive paste 29, wherein preferably both cavity parts 13A and 13B each are filled with said electrically conductive paste 29. Said paste 29 may in particular be a solder paste 29 or a sinter paste 29. To ensure that the cavity is completely filled with said conductive paste 29, at least one of the cavity parts 13A and 13B is preferably overfilled as exemplarily illustrated in Fig. 4b with respect to step S13, which shows providing sub-stack 10B for forming stack 10. Sub-stack 10A may in particular look analogously as illustrated at subsequent step S14. The first insulating layer structure of sub-stack 10A corresponding to insulating layer structure 71 of sub-stack 10B is indicated with reference sign 70. The second insulating layer structure of sub-stack 10A on the opposed side corresponding to insulating layer structure 112 of sub-stack 10B is indicated with reference sign 116.

In a further step S14, sub-stack 10A and sub-stack 10B may be stacked one above the other in stacking direction Z, in particular such that they are overlapping, in particular their electrically conductive structures or pads, to ensure direct and proper electrical connection between the embedded components 11 and 12 by the electrically conductive paste 29, by which the cavity 13 in between the components 11 and 12 is completely filled with. Thereby, cavity 13 is formed. Because of the tapered lateral walls 18 in this embodiment the cavity 13 has a hexagonal shape, as it is apparent from Fig. 4b, see for example steps S14 to S16.

Precise overlapping, i.e., an arrangement of the components 11 and 12 above each other each other in stacking direction Z within a defined tolerance of a relative translation in lateral direction X, may in particular be achieved using the alignment structures 66 and 67.

After the sub-stacks 10A and 10B have stacked one above the other in stacking direction Z and have precisely been aligned to ensure overlapping, preferably axial pressure in stacking direction Z and/or heat is applied to fully cure the parts of the formed stack 10 not being fully cured so far, and to laminate sub-stacks 10A and 10B together. The electrically insulating layer structures 70 and 71 may melt together to a common intermediate insulating layer structure 131. In some embodiments it may happen that electrically conductive paste 29 squeezes out of the cavity 13 into a contact zone located in a separation plane 32 between the first sub-stack 10A and the second sub-stack 10B in between electrically insulating layer structures 71 and 70.

Components 11 and 12 may in particular be embedded such into said stack 10 that their main surfaces are flashing with corresponding core structure layers 81 and 82, and such that the external insulating layer structures 70, 71, 112 and 116 are in contact with said component main surfaces and said core structure layers 81, 82, thus contacting at least two surfaces flushing one to each other.

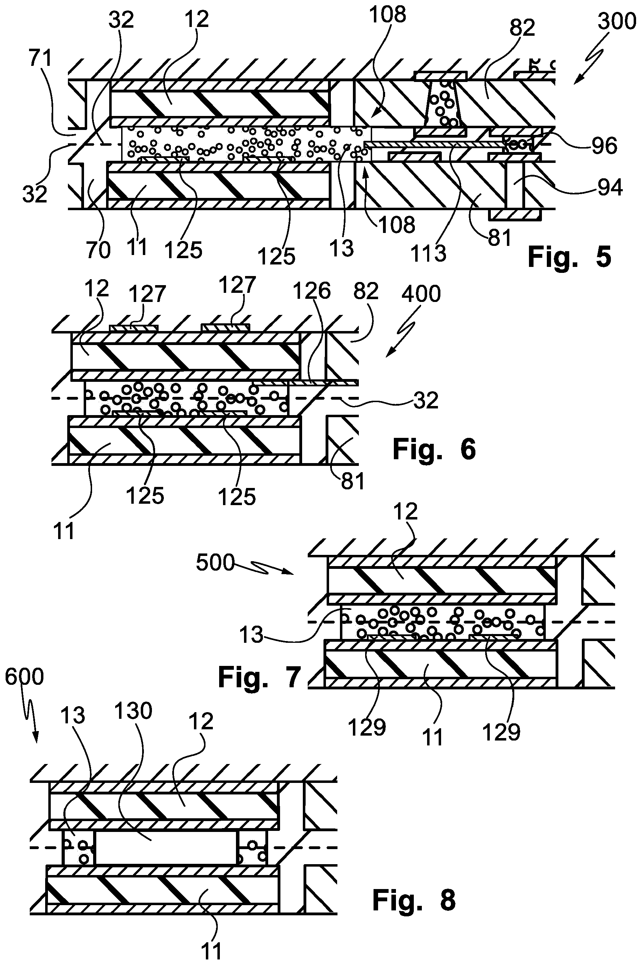

**Fig. 5** shows a sectional view of a cross-section of another exemplary embodiment of a component carrier 300 according to the present invention, wherein in this embodiment cavity 13 is extending in lateral direction so far that it is extending into a space in between core structure layers 81 and 82. Thus, cavity 13 is also partially delimited in stacking direction Z by the core structure layers 81 and 82, in particular by their main surfaces 108, which in this embodiment also form the main surfaces of the respective sub-carriers (not indicated with reference signs in Fig. 5).

In addition to the embodiments shown in Figs. 1a and 2, in this embodiment further an electrically conductive layer structure 113 is provided, by which the further electrically conductive structure 96, which is also formed by an electrically conductive paste, is connected with component 11 via electrically conductive pads 125 and the conductive paste 29 the cavity 13 is filled with. Said additional electrically conductive layer structure 113 is arranged at a contact surface in the separation plane 32 between the electrically insulating layer structures 71 and 70.

**Fig. 6** shows a sectional view of a cross-section of a further exemplary embodiment of a component carrier 400 also comprising an additional electrically conductive layer structure 126. However, in this embodiment said additional electrically conductive layer structure 126 is not arranged at a contact surface in the separation plane 32, but directly on the bottom main surface of the upper core structure layer 82 being in contact also with the bottom main surface of component 12, in particular with its electrically conductive layer structure (not further indicated) and also penetrating into said conductive paste in cavity 13.

Depending on the electrical conductivity of the bottom side of the upper component 12, in particular of structure 48 respectively the component 12 itself, via said additional electrically conductive layer structure 126 an electrical connection with both components 11 and 12 or with the lower component 11 only may be established.

In case, the bottom main surface (not indicated with a reference sign) of the upper component 12, in particular structure 48 is electrically conductive, as exemplarily illustrated here in Fig. 6, an electrical connection with the upper component 12 may be established via said electrically conductive structure 48 and via the electrically conductive layer structure 126. Via the conductive paste 29 and as exemplarily illustrated in Fig. 6, the upper component 12 is electrically connected with the lower component 11 via its pads 125 and conductive structure 49 respectively via the respective component's main surface (not indicated with a reference sign).

In at least one other possible embodiment, in particular in an alternative embodiment, structure 48 may be an electrically insulating structure 48. In this case, the additional electrically conductive layer structure 126 may be electrically connected to the lower component 11 only (but not to the upper component 12), wherein the electrical connection between the lower component 11 and the additional electrically conductive layer structure 126 may in particular be established as, for example, illustrated in Fig. 6 via the conductive paste 29 in the cavity 13 and via the pads 125 of the lower component 11 respectively via the respective component's main surface (not indicated with a reference sign).

**Fig. 7** shows a sectional view of a cross-section of a further exemplary embodiment of a component carrier 500 according to the present invention, wherein in this embodiment 500 nanowires 129 are arranged onto the main surface of component 11 delimiting cavity 13 at least partially. By the nanowires 129 the adhesion of the conductive paste to the component 11 may be improved. Thereby, an improved electrical connection may be achieved.

**Fig. 8** shows a sectional view of a cross-section of a further exemplary embodiment of a component carrier 600 according to the present invention, wherein in this embodiment 600 within cavity 13 besides the conductive paste a distance block 130 is arranged. This block 130 may in particular comprise or be made of copper and/or any other electrically conductive material. Such a block 130 may serve as distance means 130 to ensure providing a stack with a defined distance between the first component 11 and the second component 12 in stacking direction. By such a block 130 it is in particular possible in a very easy manner to ensure that the components 11 and 12 are not compressed too much during lamination and to avoid pressing out and/or squeezing out of a too high amount of the electrically conductive paste 29 out of cavity 13.

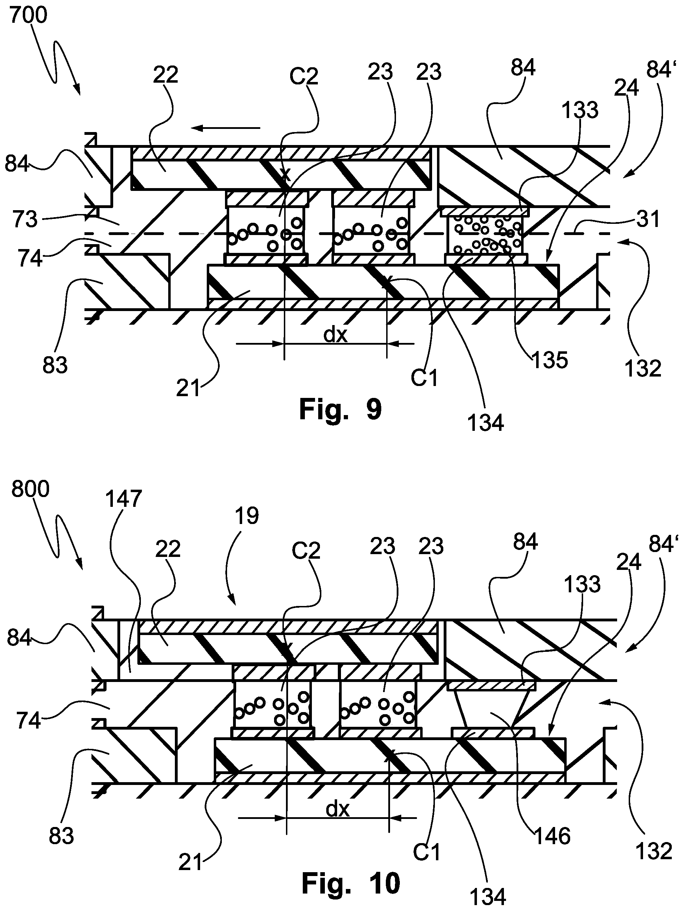

**Fig. 9** shows a sectional view of a cross-section of a further exemplary embodiment of a component carrier 700 according to the present invention, wherein this embodiment is similar to the embodiments 100 and 200 of Figs. 1a, 1b and 2 previously described. However, contrary to the embodiments 100 and 200 in this embodiment 700, the upper component 22 is significantly shifted laterally to the left, in particular by distance dx. To further ensure reliable electrical connections between the two components 21 and 22, which are also established with cavities 23 being filled with an electrically conductive paste (not indicated), the component's pads (also not indicated with reference signs) are overlapping almost exactly, i.e., almost 100%.

The lateral shift by dx of component 22 creates space above the lower component 21 in stacking direction, wherein this space is used to further connect component 21 electrically. As can be seen from Fig. 9, in this exemplary embodiment 700, component 21 is on its main surface side 24, which is also facing towards the other two cavities 23, via another pad 134, further electrically connected to a further electrically conductive structure 133. In this embodiment 700, component 21 is electrically connected to an electrically conductive structure 133 being provided on the core structure layer 84 of sub-carrier 84', in which the other component 22 said component 21 is electrically connected with, is embedded, and which is also facing towards said main surface 24 of said component 21.

In the embodiment 700 illustrated in Fig. 9, the further electrical connection is also made with a conductive paste being filled into a further cavity 135, in particular analogous to the other cavities 23, and forming a via.

In another possible embodiment, layer separation plane 31 may be located on a different vertical level (i.e., in stacking direction Z), for example flushing with a main surface of one of the core structure layers, for example with the bottom main surface of core structure layer 84 or with the upper main surface of the other core structure layer 83 in which component 21 is embedded into. The separation plane 31 may also flush with an outer material surface of an electrically conductive connection structure, for example with an outer material surface of connection structure 133 or 134.

**Fig. 10** shows another possible embodiment of a component carrier 800 according to the present invention. Instead of providing an intermediate insulating layer structure being formed of two electrically insulating layer structures 73 and 74 as illustrated in Fig. 9, in the embodiment illustrated in Fig. 10 exemplarily, this component carrier 800 comprises an intermediate insulating layer structure 132 formed of one electrically insulating layer structure 74 only, which has been applied to one of the component carrier's core structure layers only (here onto core structure layer 83), e.g. by softlamination ("softlam"), printing, in particular 3D-printing, or the like, and in which then the cavities 23 have been brought in, in particular completely, before the cavities 23 have thereafter be filled with the electrically conductive paste for establishing the electrical connection with the other component 22. Instead of being filled with electrically insulating layer material from electrically insulating layer structure 73, the spaces (not indicated herein) in cavity 19 between component 22 and core layer structure 84 may be filled with another electrically insulating material 147, for example by a glue like electrically insulating material, as exemplarily illustrated in this embodiment 800.

For establishing the electrical connection between the first component 21 and the sub-carrier 84', a further cavity 135 also being filled with an electrically conductive paste and as illustrated in Fig. 9 and described above may be provided.

However, using one electrically insulating layer structure 74 only for intermediate layer 132, allows alternatively to use a plated standard via 146 for establishment of the electrical connection between the first component 21 and the sub-carrier 84' what is exemplarily illustrated in Fig. 10. Said via 146 may in particular be created in the same process step as the other cavities 23 and plated with appropriate electrically conductive plating material as it is in general known from prior art.

After the cavities 23 respectively 135 have been filled with the electrically conductive paste or been plated forming a standard plated via 146 for establishing the electrical connection between the first component 21 and the upper sub-carrier 84', the bottom sub-stack (here not indicated with a reference sign - comprising core structure layer 83, the first component 21 and the respective connection structures (e.g. 133), and the cavities 23, 135 filled with the conductive paste respectively comprising plated via 146), and the upper sub-stack (also not indicated - comprising core structure layer 83, and the first component 21) can be stacked one above the other and laminated together, in particular under pressure and heat.

This design of a component carrier as shown in Fig. 10 with one insulating layer structure only (here 74) forming the intermediate layer (here 132) is not limited to the embodiment illustrated in Fig. 10. Also, other embodiments of a component carrier according to the present invention may be designed like this and comprise an intermediate layer formed of one electrically insulating layer structure instead of two combined by stacking one above the other.

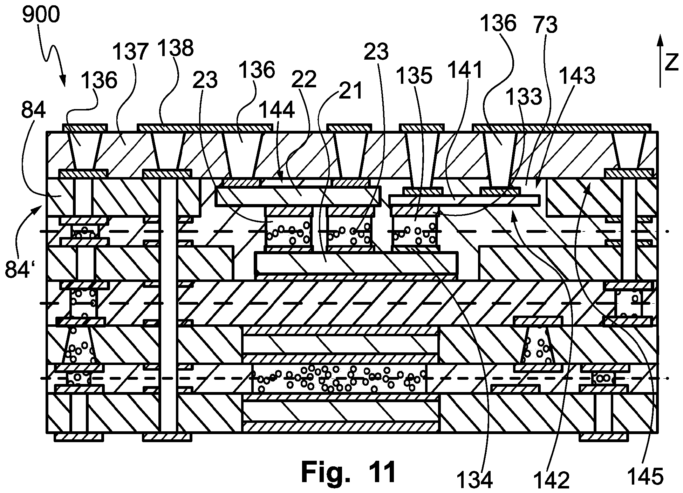

**Fig. 11** shows a cross-section through a further embodiment of a component carrier 900 according to the present invention, wherein this component carrier 900 may further comprise a third component 141, also being stacked above (at least partially) the first component 21 and also being electrically connected to said first component 21 on its main surface (side) 142 facing towards the first component 21 via a further cavity 135 in between and via connection pads 133 and 134. Said cavity 135 is also filled with an electrically conductive paste and also partially be delimited by the third component 141, in particular by its connection pad 133.

The third component 141 is embedded in the same layer structure 84, in particular in the same sub-carrier 84', as the second component 22.

The first component 21, the second component 22, and the third component 141 are electrically connected with each other, wherein in this embodiment the first component 21 acts as a bridge and is configured for bridging at least one signal from the second component 22 to the third component 141 and vice versa. Of course, another embodiment is possible, in which the third component is, for example, embedded in the same layer structure as the first component 21.

As illustrated in Fig. 10, the components 21, 22 and 141 may be of different heights (not indicated) and different sizes and/or different functionalities, although the components 22 and 141 are embedded in the same layer structure 84. The component's main surfaces may also be located on different vertical levels (i.e., in stacking direction). In the embodiment 800, for example, the upper main surface 143 opposed to main surface 142 facing cavity 135 of the third component 141 is on a different vertical level than the upper main surface 144 of the second component 22, and thus not flushing with the main surface 145 of the corresponding core structure layer 84.

The components 22 and 141 of the component carrier 800 exemplarily shown in Fig. 10 are double-sided connected components, which are each additionally electrically connected with an electrically conductive layer structure 138 on the outer surface of electrically insulating layer structure 137, which is provided on the upper surface of core structure layer 84. The electrical connections with the electrically conductive layer structure 138, in particular those with the components 22 and 141, are formed by standard plated vias 136. To establish said double-sided connections, the components 22 and 141 comprise electrically conductive connection structures on both main surface sides (here pads; not indicated with reference signs).

As the illustrated embodiments show clearly, a component carrier according to the present invention allows to embed several components of different sizes and types with a high flexibility regarding their arrangement within the component carrier and/or within a stack with a high amount of possible reliable connection possibilities in a very compact and space saving manner. Thereby, at least in some embodiments, connection density may be increased, and miniaturization may be enhanced.

### LIST OF REFERENCE SIGNS

- 100: first exemplary embodiment of a component carrier according to the present invention
- 200: second exemplary embodiment of a component carrier according to the present invention
- 300: further exemplary embodiment of a component carrier according to the present invention
- 400: further exemplary embodiment of a component carrier according to the present invention
- 500: further exemplary embodiment of a component carrier according to the present invention
- 600: further exemplary embodiment of a component carrier according to the present invention
- 700: further exemplary embodiment of a component carrier according to the present invention
- 800: further exemplary embodiment of a component carrier according to the present invention
- 900: further exemplary embodiment of a component carrier according to the present invention

- 10: first stack
- 11: first component of the first stack
- 12: second component of the first stack
- 13: cavity between the first component and the second component of the first stack filled with electrically conductive paste
- 13A: first part of the cavity between the first component and the second component of the first stack filled with electrically conductive paste
- 13B: second part of the cavity between the first component and the second component of the first stack filled with electrically conductive paste
- 14, 16: main surfaces of the components of the first stack facing towards the cavity of said stack
- 15, 17: main surfaces of the components of the first stack facing away from the cavity of said stack
- 18: lateral wall of cavity connecting the two components of the first stack
- 19: component cavity
- 10A, 20A: first sub-stack
- 10B, 20B: second sub-stack
- 20: second stack
- 21: first component of the second stack
- 22: second component of the second stack
- 23: cavity between the first component and the second component of the second stack being filled with electrically conductive paste
- 24, 26: main surfaces of the components of the second stack facing towards the cavity of said stack
- 25, 27: main surfaces of the components of the second stack facing away from the cavity of said stack
- 28: lateral wall of cavity connecting the two components of second first stack
- 29: electrically conductive paste
- 30: separation plane between the first stack and the second stack; contact surface between adjacent layer structures
- 31, 32: separation plane between the first sub-stack and the second sub-stack; contact surface between adjacent layer structures
- 40..45, 55..67: electrically conductive layer structure
- 46..54, 68: electrically conductive connection structure of a component
- 70..74: electrically insulating layer structure
- 70, 71: first electrically insulating layer structure forming the intermediate layer of the first stack at least partially
- 72: electrically insulating layer structure between the first stack and the second stack
- 73, 74: first electrically insulating layer structure forming the intermediate layer of the second stack at least partially
- 75, 76, 99, 101: portion of the electrically insulating layer structure extending into a space between the component and the lateral wall of the core structure layer
- 81', 82': sub-carrier of the first stack
- 83', 84': sub-carrier of the second stack
- 81..84: core structure layer
- 90..94: through hole connections, in particular vias
- 96: further cavity filled with electrically conductive paste
- 97, 98: space between the component and the lateral wall of the core structure layer
- 102..107: opening in the electrically conductive structure
- 108: main surface of core structure layer
- 109: temporary carrier layer structure
- 110, 111: horizontal portion of the electrically insulating layer structure
- 112, 116: second insulating layer structure
- 113: electrically conductive layer structure at the contact surface between two insulating layer structures
- 114, 115: openings in the second electrically insulating layer structure
- 117..121: electrically conductive (layer) structure
- 122: portion of electrically insulating layer structure
- 123, 124: opening in electrically conductive structure
- 125, 127: electrically conductive (layer) structure
- 126: electrically conductive layer structure at the contact surface between the first insulating layer structure and the main surface of the core structure layer
- 128: second main surface of core structure layer
- 129: nanowire structure (layer)
- 130: distance block
- 131, 132: intermediate electrically insulating layer structure
- 133, 134: conductive connection structure
- 135: cavity filled with electrically conductive paste
- 136: vias, in particular plated connection
- 137: electrically insulating layer structure
- 138: electrically conductive layer structure
- 141: third component
- 142, 143: main surface of third component
- 144: main surface of second component
- 145: main surface of core structure layer
- 146: plated standard via
- 147: electrically insulating material

- C1: geometric center of first component in lateral direction
- C2: geometric center of second component in lateral direction
- dx: lateral shift between components
- ox: lateral extension of non-overlapping area of a component
- px: lateral shift between pads
- H1: height of first component in lateral direction
- H2: height of second component in lateral direction
- L1: length of first component in lateral direction
- L2: length of second component in lateral direction
- X: lateral direction, in particular perpendicular to stacking direction
- Z: stacking direction

## Claims

1. A component carrier (100, 200, 300, 400, 500, 600, 700, 800, 900) comprising:
a stack (10, 20) having a stacking direction (Z) and comprising at least one electrically insulating layer structure (70-74; 131, 132, 137) and at least one electrically conductive layer structure (40-45, 55-67; 112-113; 116-121; 125-127; 129, 138), and further comprising at least a first component (11, 21) and a second component (12, 22) embedded in said stack (10, 20) one above the other in said stacking direction (Z) with a cavity (13, 23, 135) in between,
wherein the first component (11, 21) and the second component (12, 22) each comprise a component main surface (14, 16; 24, 26) facing towards said cavity (13, 23) and delimiting said cavity (13, 23) in stacking direction (Z) partially, and
wherein said cavity (13, 23) is filled with an electrically conductive paste (29).

2. Component carrier (100, 200, 300, 400, 500, 600, 700, 800, 900) according to claim 1, wherein the first component (11, 21) and the second component (12, 22, 141) are electrically connected with each other by said electrically conductive paste (29).

3. Component carrier (100, 200, 300, 400, 500, 600, 700, 800, 900) according to any one of the preceding claims, wherein the cavity (13, 23) is partially delimited in lateral direction by at least one layer structure (70-76; 99, 101) of said stack (10, 20).

4. Component carrier (100, 200, 300, 400, 500, 600, 700, 800, 900) according to any one of the preceding claims, wherein the component carrier (100, 200, 300, 400, 500, 600, 700, 800, 900) comprises a first sub-carrier (82', 84') and a second sub-carrier (81', 83'), stacked one above the other in stacking direction (Z), in particular wherein the first sub-carrier (82', 84') and the second sub-carrier (81', 83') each comprise a sub-carrier main surface (108) facing towards said cavity (13, 23), wherein the cavity (13, 23) is in particular also partially delimited in stacking direction (Z) by at least one of the sub-carrier main surfaces (108) and/or in particular wherein the stack (10, 20) comprises at least a first sub-stack (10A, 20A) and a second sub-stack (10B, 20B), stacked one above the other in stacking direction (Z).

5. Component carrier (100, 200, 300, 400, 500, 600, 700, 800, 900) according claim 4, wherein at least one sub-carrier (82', 84') comprises a core structure layer (81, 82, 83, 84), the core structure layer (81, 82, 83, 84) comprising at least one component cavity (19), wherein in said at least one component cavity (19) at least one component is embedded, preferably the first component (11, 21) or the second component (12, 22).

6. Component carrier (100, 200, 300, 400, 500, 600, 700, 800, 900) according to any one of the claims 4 to 5, wherein the first sub-stack (10A, 20A) encompasses the first component (11, 21), and wherein the second sub-stack (10B, 20B) encompasses the second component (12, 22).

7. Component carrier (100, 200, 300, 400, 500, 600, 700, 800, 900) according to claim 6, wherein at least one sub-stack (10A, 10B; 20A, 20B) further comprises at least a first external insulating layer structure (70, 71; 73, 74), said first external insulating layer structure (70, 71; 73, 74) in particular forming at least a part of the intermediate layer structure (131, 132).

8. Component carrier (100, 200, 300, 400, 500, 600, 700, 800, 900) according to any one of the claims 4 to 7, wherein the component carrier (100, 200, 300, 400, 500, 600, 700, 800, 900) further comprises at least one alignment structure (66, 67, 102-107) being provided on and/or in at least one sub-carrier (81', 82', 83', 84'), in particular on and/or in at least one sub-stack (10A, 10B, 20A, 20B), at least partially, in particular wherein at least one alignment structure (66, 67, 102-107) is configured for an alignment an the intermediate layer (131, 132) and/or the alignment of the paste (29) and/or the alignment of a sub-carrier (81', 82', 83', 84') and/or the alignment of a sub-stack (10A, 10B, 20A, 20B) and/or combinations thereof and/or an alignment of at least two of them relatively to each other.

9. Component carrier (100, 200, 700, 800, 900) according to any one of the preceding claims, wherein at least two components (11, 12; 21, 22) being stacked one above the other, in particular at least the first component (11, 21) and the second component (12, 22), are stacked one above the other with a defined lateral shift (dX) in lateral direction (X) relative to each other.

10. Component carrier (900) according to any one of the preceding claims, wherein the component carrier (900) comprises further at least a third component (141), wherein said third component (141) is also embedded in said stack (10, 20) and being stacked with the first component (21) and/or the second component (22) in stacking direction (Z) with a cavity (135) in between, wherein the third component (141) also comprises a component main surface (142) facing towards said cavity (135) and delimiting said cavity (135) in stacking direction (Z) partially, and wherein said cavity (135) is filled with an electrically conductive paste.

11. Component carrier (900) according to claim 10, wherein the first component (21), the second component (22), and the third component (141) are electrically connected with each other, wherein one of the components (21) acts as a bridge and is in particular configured for bridging at least one signal from one component (22) to the other (141), in particular from one component (22) of the other two components (22, 141) to the other one of said two components (141).

12. Component carrier (300, 400) according to any one of the preceding claims, wherein at least one electrically conductive layer structure (113, 126) is provided such that it contacts the conductive paste (29) at its lateral side and/or penetrates into the conductive paste (29) from the lateral side of said cavity (13).

13. A method for manufacturing a component carrier (100, 200, 300, 400, 500, 600, 700, 800, 900), the method comprising at least the following steps:
a) providing a first component (11, 21) and a second component (12, 22) each component (11, 12, 21, 22) comprising a component main surface (14, 16, 24, 26),
b) forming a stack (10, 20) having a stacking direction (Z) and comprising at least one electrically insulating layer structure (70-74) and at least one electrically conductive layer structure (40-45, 55-67; 112-113; 116-121; 125-127; 129), wherein forming said stack (10, 20) includes:
embedding the first component (11, 21) and the second component (12, 22) one above the other in stacking direction (Z) and with a cavity (13, 23) in between and with their main surfaces (14, 16, 24, 26) facing towards said cavity (13, 23) and delimiting said cavity (13, 23) in stacking direction (Z) partially, and
filling said cavity (13, 23) with an electrically conductive paste (29); and
c) providing a component carrier (100, 200, 300, 400, 500, 600, 700, 800, 900) with the formed stack (10, 20).

14. Method according to claim 13, wherein forming the stack (10, 20) includes:
forming a first sub-stack (10A, 20A) comprising the first component (11, 21) and a first part (13A) of said cavity (13, 23) to be filled with the electrically conductive paste (29), wherein the first component (11, 21) is at least partially being embedded into said first sub-stack (10A, 20A),
forming a second sub-stack (10B, 20B) comprising the second component (12, 22) and a second part (13B) of said cavity (13, 23) to be filled with the electrically conductive paste (29), wherein the second component (12, 22) is at least partially being embedded into said first sub-stack (10A, 20A),
filling the first part of said cavity (13, 23) and/or the second part of said cavity (13, 23) with the electrically conductive paste (29), and
providing the first sub-stack (10A, 20A) and the second sub-stack (10B, 20B) one above the other in stacking direction (Z) with the first part of the cavity (13, 23) and the second part of the cavity (13, 23) facing to each other, thereby composing the cavity (13, 23) between the first component (11, 21) and the second component (12, 22) of the first part of the cavity (13, 23) of the first sub-stack (10A, 20A) and the second part of the cavity (13, 23) of the second sub-stack (10B, 20B).

15. A package, comprising at least one component carrier (100, 200, 300, 400, 500, 600, 700, 800, 900) according to any one of the claims 1 to 12 and/or at least one component carrier (100, 200, 300, 400, 500, 600, 700, 800, 900) manufactured by a method according to any of the claims 13 to 14, and a least one further part being assembled with the component carrier (100, 200, 300, 400, 500, 600, 700, 800, 900).
